# EUROPEAN PATENT SPECIFICATION

(11) **EP 3 674 438 B1**
(45) Date of publication and mention of the grant of the patent: **29.03.2023**
(21) Application number: 18849178.1
(22) Date of filing: 12.04.2018
(51) Int. Cl.: C23C 16/455, C23C 16/50, C23C 16/458, C23C 16/515, C23C 16/517, C23C 16/56, C23C 14/12, B05D 1/34, B05D 5/08, B05D 1/00

(54) **PREPARATION METHOD FOR HIGH INSULATION NANO-PROTECTIVE COATING HAVING MODULATION STRUCTURE**
HERSTELLUNGSVERFAHREN EINER HOCHISOLIERENDEN NANOSCHUTZSCHICHT MIT MODULATIONSSTRUKTUR
PROCÉDÉ DE PRÉPARATION D'UN NANOREVÊTEMENT PROTECTEUR À ISOLATION ÉLEVÉE AYANT UNE STRUCTURE DE MODULATION

(30) Priority: 23.08.2017 CN 201710729732
(43) Date of publication of application: 01.07.2020
(73) Proprietor: Jiangsu Favored Nanotechnology Co., Ltd., Donghuan Rd., Yuqi Industrial Park Wuxi Jiangsu 214183 (CN)
(72) Inventor: ZONG, Jian, Wuxi Jiangsu province (CN)
(74) Representative: Yalçiner Patent and Consulting Ltd.
(86) International application number: PCT/CN2018/082837
(87) International publication number: WO 2019/037446

(56) References cited:
- WO-A1-2014/078497
- CN-A- 101 678 642
- CN-A- 105 296 965
- CN-A- 106 906 456
- CN-A- 106 916 331
- CN-A- 106 958 012
- CN-A- 107 058 979
- CN-A- 107 058 979
- CN-A- 107 058 980
- CN-A- 107 587 119
- CN-A- 107 587 120
- CN-A- 107 686 986
- US-A1- 2015 123 090
- YE, DANQIN et al.: "Preparation and Performance of Multilayer Films by RF Plasma Polymerization", Journal of Tianjin University of Technology, vol. 4, 31 August 2008 (2008-08-31), pages 1-4, XP055679038, ISSN: 1673-095X

## Description

### Technical field

The present invention belongs to the technical field of plasma chemical vapor deposition, and particularly relates to a method for preparing a nano-protective coating.

### Background

Anti-mold, anti-moisture, anti-salt mist (simply referred to as three antis) are important problems that need to be solved during storage, transportation and use of electronic devices. Moreover, mold, salt mist, and moisture often cause electronic devices to fail due to short circuits. Therefore, for protective coatings applied in the electronics industry, in addition to having excellent "three-anti" performance, they must also have good insulation.

At present, the use of protective coatings to protect electronic products is an effective method to increase the service life of electronic products. There are usually two methods for obtaining protective coatings, namely, a liquid phase method and a vapor phase method. The liquid phase method usually uses three-anti paint. After coating electronic products, a thermal curing or a light curing is performed to form a dense organic coating on a circuit board, which is used to protect the circuit board and its related equipment from environmental erosion. The three-anti paint has good high-and-low-temperature resistance properties. After curing, the three-anti paint forms a transparent protective film, which has excellent properties such as insulation, moisture resistance, leakage resistance, shock resistance, dust resistance, corrosion resistance, aging resistance, and corona resistance. However, the liquid phase method may generate waste water, waste gas and waste liquid. The solvent used may cause certain damage to the base material of the electronic device. In addition, its thickness is mostly tens of microns, which is difficult to control at the nanometer level. For some electronic devices that require heat dissipation and signal transmission, there may be a certain impact.

The vapor phase method includes methods such as evaporation and plasma vapor deposition. The most typical evaporation coating is a Parylene coating, which is developed by the United States Union Carbide Co. and widely used in the protection of electronic products. The Parylene coating is a polymer of para-xylene, wherein para-xylene is first heated to 680°C to form an active para-xylene dimmer, and after the temperature in a deposition chamber is reduced, this dimer is deposited on the surface of an electronic product to form a polymer film. Due to the highly symmetrical structure of para-xylene, the dipole moment is 0, and the polymer molecule has a large free volume due to the presence of a benzene ring; and at the same time, the polymer has a relatively large molecular weight, which results in a high coating density. Due to the above characteristics, the Parylene coating has low water and gas permeability, and a high barrier effect, and can achieve the effects of moisture resistance, water resistance, rust resistance, and resistance to acid and alkali corrosion. This poly-p-xylylene is produced by deposition in a vacuum state, and may be applied to the fields where liquid coatings cannot be used, such as the protection of high-frequency circuits and extremely weak current systems. The thickness of the polymer film coating is the main reason that causes the protective failure of the poly-p-xylylene vapor deposited conformal coating. A polymer film coating of a printed circuit board assembly is prone to local rust failure at the thickness of 3 to 7 microns. The coating thickness should be ≥30 microns without affecting the high frequency dielectric loss. The Parylene coating has higher requirements for the pre-treatment of printed circuit boards that need protection, such as conductive components, signal transmission components, and RF components. During vapor phase deposition of a conformal coating, it is necessary to perform a pre-treatment of shielding the circuit board assemblies to avoid affecting the performance of the assemblies. This disadvantage has greatly limited the application of Parylene coatings. The Parylene coatings have high raw material costs for preparation, harsh coating preparation conditions (high temperature and high vacuum requirements), and low film formation rates, and thus the Parylene coatings are difficult to be widely used. In addition, thick coatings are likely to cause problems such as poor heat dissipation, signal blocking, and increased coating defects.

In view of the above problems, it is of great application value to develop a coating that is environmentally friendly, has a good insulation property, and has an excellent protective property when the coating is thinner, and a preparation method.

Plasma chemical vapor deposition (PCVD) is a technology that activates a reactive gas with plasma to promote a chemical reaction on a base material surface or in a space near the base material surface to generate a solid film. The plasma chemical vapor deposition coating has the following advantages:
(1) It is a dry process, and the generated film is uniform without pinholes.
(2) The chemical and physical properties such as solvent resistance, chemical corrosion resistance, heat resistance, and abrasion resistance of the plasma polymer film are stable.
(3) The plasma polymer film has good adhesion to the base material.
(4) A uniform film can also be made on an extremely irregular base material surface.
(5) The coating preparation temperature is low, and it can be carried out under normal temperature conditions, effectively avoiding damage to temperature sensitive devices.
(6) The plasma process can not only prepare coatings with a thickness of micron level, but also may prepare ultra-thin nano-scale coatings.
(7) The coating can be highly designed. Under plasma conditions, most organic monomers can be activated into free radicals with higher activity, and form coatings on the surfaces of electronic products. The screening and design of monomer dipole moment, chemical inertia, and free volume are important strategies to obtain coatings with good insulation and having excellent protective performance at a thinner thickness.
(8) The coating structure is highly controllable, and the composition and proportion of monomers can be changed at any time, so that the coating has special structures such as having multiple layers, gradients and modulations.
(9) Inorganic and organic composite structural coatings can be prepared.

At present, for a coating with a single structure or a single component, the performance is relatively single. To improve its protective performance, the thickness must be increased, and the increase in thickness may in turn lead to a decrease in the performance such as heat dissipation and signal transmission.

The following document shows a conventional method for preparing a nano-protective coating:
D1: CN 107 058 979 A (WUXI RJ IND Co Ltd) 18 August 2017.

### Summary

In order to solve the above technical problems, the present invention provides a method for preparing a highly insulating nano-protective coating with a modulation structure.

A method for preparing a highly insulating nano-protective coating according to the invention is defined in the appended claims.

In the preparation process, organic monomers with low dipole moment and high chemical inertness are selected, and the free volume and compactness of the coating are adjusted by a polyfunctional monomer, so that the coating has high insulation and excellent protection at the same time. Meanwhile, in this preparation process, the low-dipole moment organic coating and organic silicon coating are alternately prepared or the low-dipole moment organic coating and organic fluorocarbon coating are alternately prepared to form a low-dipole moment-organic silicon/fluorocarbon modulation multi-layer compact structure, and the design of the composite modulation multi-layer structure can greatly improve the protective performance of the coating without loss of the heat conduction and signal transmission performance.

Since the plasma chemical vapor deposition method is not only applicable to a variety of monomers, but also has a strong controllability on the composition and structure of the formed coating, the composition and structure of the coating are adjusted and constructed through the design of the monomer and the optimization of process parameters, and a nano-protective coating with a modulation structure can be designed. The interface between layers is used to prevent the longitudinal diffusion of corrosion; and at the same time, due to the superlattice effect of the modulation nano-layered structure, the accumulation of dislocations between the layers makes the coating less prone to breakdown, and the power-on capability under water resistance is effectively improved. This modulation structure coating has better protection and insulation performance than existing coatings such as Parylene coatings at the same thickness. Protection and insulation can be achieved in the case of a lower thickness, which solves many problems that currently exist when using coatings such as Parylene, such as large thickness, low production efficiency, poor heat dissipation, and signal blocking.

A technical solution adopted by the present invention is as follows:
A method for preparing a highly insulating nano-protective coating with a modulation structure, characterized by including the following steps:
   (1) pre-treatment:
      placing a base material in a reaction chamber of nano-coating preparation equipment, continuously vacuumizing the reaction chamber so that a degree of vacuum in the reaction chamber reaches 10 to 200 mTorr, introducing the inert gas He or Ar or a mixed gas of He and Ar, and turning on a movement mechanism to make the base material move in the reaction chamber;
   (2) preparation of the highly insulating nano-coating:
      performing the following steps at least once to prepare a nano-coating with a high insulation modulation structure on a surface of the base material:
         introducing monomer A vapor into the reaction chamber to the degree of vacuum of 30 to 300 mTorr, turning on plasma discharge to perform chemical vapor deposition, stopping the introduction of monomer A vapor, introducing monomer B or monomer C vapor, continuing the plasma discharge to perform chemical vapor deposition, and stopping the introduction of the monomer B or monomer C vapor;
      the composition of the monomer A vapor including:
         a mixture of at least one low-dipole moment organic monomer and at least one unsaturated hydrocarbon, polyfunctional unsaturated hydrocarbon and hydrocarbon derivative, wherein a mass fraction of the unsaturated hydrocarbon, polyfunctional unsaturated hydrocarbon and hydrocarbon derivative in the monomer A vapor is 15% to 65%;
      the composition of the monomer B vapor including:
         a mixture of at least one monofunctional unsaturated fluorocarbon resin and at least one unsaturated hydrocarbon, polyfunctional unsaturated hydrocarbon and hydrocarbon derivative, wherein a mass fraction of the unsaturated hydrocarbon, polyfunctional unsaturated hydrocarbon and hydrocarbon derivative in the monomer B vapor is 15% to 65%;
      the composition of the monomer C vapor including:
         a mixture of an organic silicon monomer including a double-bond, Si-Cl, Si-O-C, Si-N-Si, or Si-O-Si structure or a cyclic structure and at least one unsaturated hydrocarbon, polyfunctional unsaturated hydrocarbon and hydrocarbon derivative, wherein a mass fraction of the unsaturated hydrocarbon, polyfunctional unsaturated hydrocarbon and hydrocarbon derivative in the monomer C vapor is 15% to 65%;
      the introducing the monomer A vapor, the monomer B vapor and the monomer C vapor is to atomize and volatilize the monomers through a feed pump and introduce them into the reaction chamber under a low pressure of 10 to 200 mTorr, and flow rates of introducing the monomer A, the monomer B and the monomer C each are 10 to 1000 µL/min; and
   (3) post-treatment:
      stopping the plasma discharge, continuing to vacuumize to maintain the degree of vacuum of the reaction chamber at 10 to 200 mTorr, after 1 to 5 min, introducing air to an atmospheric pressure, stopping the movement of the base material, and then taking out the base material;
      or, stopping the plasma discharge, aerating the reaction chamber with the air or the inert gas to the pressure of 2000 to 5000 mTorr, then vacuumizing to 10 to 200 mTorr, performing the above aeration and vacuumization steps at least once, introducing the air to one atmospheric pressure, stopping the movement of the base material, and then taking out the base material.

In a low-vacuum plasma discharge environment, through the effective output of energy, the more active chemical bonds in the molecular structure of the monomer are controlled to be broken to form free radicals with higher activity. The free radicals are combined with surface-active groups of an electronic product through chemical bonds to form a nano-thin film by polymerization, and finally form a highly insulating protective coating on the surface of the base material.

The base material in the step (1) generates movement in the reaction chamber, a form of the movement of the base material is that the base material performs a linear reciprocating motion or a curvilinear motion relative to the reaction chamber, and the curvilinear motion includes circular motion, elliptical motion, planetary motion, spherical motion, or curvilinear motion of other irregular routes.

The base material in the step (1) is a solid material, the solid material is an electronic product, an electrical component, an electronic assembly semi-finished product, a printed circuit board (PCB), a metal plate, a polytetrafluoroethylene sheet or an electronic component, and after the surface of the base material is prepared with an organosilicon nano-coating, any interface thereof can be exposed to a water environment, a mold environment, and an acidic or alkaline solvent environment, an acidic or alkaline salt mist environment, an acidic atmospheric environment, an organic solvent immersion environment, a cosmetics environment, a sweat environment, a cold and heat cycle impact environment or a wet and heat alternating environment for use.

The reaction chamber in the step (1) is a rotating body-shaped chamber or a cube-shaped chamber with a volume of 50 to 1000 L, the temperature in the reaction chamber is controlled at 30 to 60°C, and the inflow rate of the inert gas is 5 to 300 sccm.

In the step (2): the monomer A vapor and the monomer B vapor or the monomer C vapor is introduced, the plasma discharge is carried out to perform chemical vapor deposition, and in the deposition process, the plasma discharge process includes low-power continuous discharge, pulse discharge, or periodic alternate discharge.

The plasma discharge process in the deposition process is the low-power continuous discharge, which specifically includes the following deposition processes at least once:
the deposition process includes a pre-treatment stage and a coating stage, in the pre-treatment stage, plasma discharge power is 150 to 600 W, continuous discharge time is 60 to 450 s, and then it enters the coating stage, in which the plasma discharge power is adjusted to 10 to 150 W, and the continuous discharge time is 600 to 3600 s.

The plasma discharge process in the deposition process is the pulse discharge, which specifically includes the following deposition processes at least once:
the deposition process includes a pre-treatment stage and a coating stage, in the pre-treatment stage, plasma discharge power is 150 to 600 W, continuous discharge time is 60 to 450 s, then it enters the coating stage, and the coating stage is pulse discharge, in which the power is 10 to 300 W, the time is 600 s to 3600 s, the frequency of pulse discharge is 1 to 1000 HZ, and the duty cycle of pulse is 1: 1 to 1: 500.

The plasma discharge process in the deposition process is the periodic alternate discharge, which specifically includes the following deposition processes at least once:
the deposition process includes a pre-treatment stage and a coating stage, in the pre-treatment stage, plasma discharge power is 150 to 600 W, continuous discharge time is 60 to 450 s, and then it enters the coating stage, in which the plasma is a periodic alternating discharge output, the power is 10 to 300 W, the time is 600 s to 3600 s, the alternating frequency is 1 to1000 Hz, and the waveform of the periodic alternating discharge output of the plasma is a sawtooth waveform, a sine waveform, a square wave waveform, a full-wave rectified waveform or a half-wave rectified waveform.

The low-dipole moment organic monomer includes:
paraxylene, benzene, toluene, carbon tetrafluoride, α-methylstyrene, polyparaxyl chloride, dimethylsiloxane, polydimethylsiloxane with the molecular weight of 500 to 50,000, allylbenzene, decafluorobiphenyl, decafluorobenzophenone, perfluoroallylbenzene, tetrafluoroethylene, hexafluoropropylene, 1H,1H-perfluorooctylamine, perfluoroiodododecane, perfluorotributylamine, 1,8-diiodoperfluorooctane, perfluorohexyliodoane, perfluoroiodobutane, perfluoroiododecane, perfluorooctyliodoane, 1,4-bis(2',3'-epoxypropyl)perfluorobutane, dodecafluoro-2-methyl-2-pentene, 2-(perfluorobutyl)ethyl methacrylate, 2-(perfluorooctyl)ethyl methacrylate, 2-(perfluorooctyl)iodoethane, perfluorodecyl ethyl iodide, 1,1,2,2-tetrahydroperfluorohexyl iodide, perfluorobutyl ethylene, 1H,1H,2H-perfluoro-1-decene, 2,4, 6-tri s(perfluoroheptyl)-1,3, 5-triazine, perfluorohexylethylene, 3-(perfluoron-octyl)-1,2,2-propylene oxide, perfluorocyclic ether, perfluorododecyl ethylene, perfluorododecyl ethyl iodide, dibromo-p-xylene, and 1,1,4,4-tetraphenyl-1,3-butadiene;
the monofunctional unsaturated fluorocarbon resin includes:
   3-(perfluoro-5-methylhexyl)-2-hydroxypropylmethacrylate, 2-(perfluorodecyl)ethylmethacrylate, 2-(perfluorohexyl)ethylmethacrylate, 2-(perfluorododecyl)ethyl acrylate, 2-perfluorooctyl ethyl acrylate, 1H,1H,2H,2H-perfluorooctanol acrylate, 2-(perfluorobutyl)ethyl acrylate, (2H-perfluoropropyl)-2-acrylate, (perfluorocyclohexyl)methacrylate, 3,3,3-trifluoro-1-propyne, 1-ethynyl-3,5-difluorobenzene or 4-ethynyltrifluorotoluene;
the organic silicon monomer including the double bond, Si-Cl, Si-O-C, Si-N-Si, Si-O-Si structure or the cyclic structure includes:
   the organic silicon monomer with the double bond structure: allyltrimethoxysilane, vinyltriethoxysilane, vinyltrimethylsilane, 3-butenyltrimethylsilane, vinyltributanone oxime silane, tetramethyldivinyldisiloxane, and 1,2,2-trifluorovinyltriphenylsilane;
   the organic silicon monomer including the Si-Cl bond: triphenylchlorosilane, methylvinyldichlorosilane, trifluoropropyltrichlorosilane, trifluoropropylmethyldichlorosilane, dimethylphenylchlorosilane , tributylchlorosilane, and benzyldimethylchlorosilane;
   the organic silicon monomer with the Si-O-C structure: tetramethoxysilane, trimethoxyhydrosiloxane, n-octyltriethoxysilane, phenyltriethoxysilane, vinyltri(2-methoxy ethoxy)silane, triethylvinylsilane, hexaethylcyclotrisiloxane, 3-(methacryloyloxy)propyltrimethoxysilane, phenyltri(trimethylsiloxane)silane, diphenyldiethoxysilane, dodecyltrimethoxysilane, n-octyltriethoxysilane, dimethoxysilane, and 3-chloropropyltrimethoxysilane;
   the organic silicon monomer including the Si-N-Si or Si-O-Si structure: hexamethyldisilazylamine, hexamethylcyclotrisilaneamino, hexamethyldisilazane, and hexamethyldisilazide;
   the organic silicon monomer including the cyclic structure: hexamethylcyclotrisiloxane, octamethylcyclotetrasiloxane, hexaphenylcyclotrisiloxane, decamethylcyclopentasiloxane, octaphenylcyclotetrasiloxane, triphenylhydroxysilane, diphenyldihydroxysilane, bis(tritylsilyl)chromate, trifluoropropylmethylcyclotrisiloxane, 2,2,4,4-tetramethyl-6,6,8,8-tetraphenylcyclotetrasiloxane, tetramethyltetravinylcyclotetrasiloxane, 3-glycidyl ether oxypropyltriethoxysilane, and γ-glycidyl ether oxypropyltrimethoxysilane; and
   the unsaturated hydrocarbon, polyfunctional unsaturated hydrocarbons and hydrocarbon derivatives includes:
      1,3-butadiene, isoprene, 1,4-pentadiene, ethoxylated trimethylolpropane triacrylate, tripropylene glycol diacrylate, polyethylene glycol diacrylate, 1,6-hexanediol diacrylate, ethylene glycol diacrylate, diethylene glycol divinyl ether, or neopentyl glycol diacrylate.

In the step (2), a mode of the plasma discharge is radio-frequency discharge, microwave discharge, intermediate-frequency discharge, high-frequency discharge, or electric spark discharge, waveforms of the high-frequency discharge and the intermediate-frequency discharge are sinusoidal or bipolar pulses, and radio-frequency plasma is plasma generated by using a high-frequency electromagnetic field discharge. A microwave method is the use of microwave energy to excite the plasma, which has the advantage of high energy utilization efficiency. At the same time, because of electrodeless discharge, the plasma is pure. It is currently an excellent method for high-quality, high-speed, large-area preparation.

In the coating preparation process, the movement property of the base material and the plasma discharge energy are combined and linked. In the preparation process, at the same time as the plasma discharge, the base material moves, improving the coating deposition efficiency and improving the uniformity and compactness of the coating thickness.

The prepared coating has insulation, water resistance, moisture resistance, mold resistance, acidic and alkaline solvent resistance, acidic and alkaline salt mist resistance, acidic atmosphere resistance, organic solvent immersion resistance, cosmetics resistance, sweat resistance, and cold and heat cycle impact (-40°C to +75°C) resistance, wet and heat alternating (humidity 75% to 95%) resistance and other properties. With the above-mentioned protective performance, the effect of the coating having the thickness of 1 to 1000 nm on the radio-frequency communication signal with a frequency in the range of 10 M to 8 G is less than 5%.

Compared with the prior art, the above technical solution of the present invention has the following advantages:
1. The plasma chemical vapor deposition technology is more environmentally friendly than the three-anti-coating applying method of the liquid phase method; and has a lower deposition temperature, a higher speed, stronger controllability on the coating structure and composition, and stronger monomer selectivity than the evaporation Parylene method.
2. The base material moves in the reaction chamber, so that the thicknesses of coatings coated on different parts of the base material tend to be the same, which solves the problem of uneven coating thickness on the surface of the base material due to the different monomer density in different regions of the reaction chamber. In the preparation process, the movement property of the base material is combined and linked with the plasma discharge energy, and the base material is moved while the discharge energy is output, improving the deposition efficiency and causing the compactness of the obtained protective coating to be significantly improved. Meanwhile, due to the increased deposition efficiency, the amount of chemical monomer raw materials used for monomer vapor is only 10% to 15% of that used in other existing technologies, thereby reducing emissions of exhaust gas, which is more environmentally friendly, and is of great significance for improving the actual production efficiency.
3. In the present invention, the organic monomers with low dipole moment and high chemical inertness are selected, and the free volume and compactness of the coating are adjusted by a polyfunctional monomer, so that the coating has high insulation and excellent protection at the same time.
   (1) In the present invention, a highly symmetrical benzene ring and a benzene derivative or a perfluorinated compound thereof are selected as monomers. After polymerization, the molecules have low polarity because the molecules are symmetrical or each carbon atom is covered with a large number of fluorine atoms, the dielectric constant thereof is very low, which is less than 2.7, and the insulation is high.
   (2) Since the benzene ring structure and fluorocarbon structure have higher chemical inertness, the polymers formed by them have excellent chemical stability.
   (3) The compactness and free volume of the coating can be effectively improved through the length and functionality of the molecular chain of the crosslinking agent, thereby improving the insulation and protection.
   (4) By the introduction of other monomers having cross-linked structures, the monomer ratio is controlled. According to the molecular bond energy, bond length difference, and vaporization temperature difference of different monomers, the corresponding energy output of the equipment is given and the process parameters are effectively changed to obtain a polymer nano-coating with a modulation, composite, and graded structure, such as a coating with a high insulation layer-fluorocarbon layer-high insulation layer-fluorocarbon layer structure, which not only ensures the insulation of the thin film, but also improves environmental corrosion resistance of products such as electronic products.
4. In the present invention, a low-dipole moment-organic silicon/fluorocarbon modulation multi-layer compact structure is formed by means of alternately performing low-dipole moment organic coating preparation and organic silicon coating preparation or low-dipole moment organic coating preparation and organic fluorocarbon coating preparation, which can reduce stress of the coating and increase toughness of the coating. At the same time, since a lateral interface is present between the low-dipole moment-the organic silicon/fluorocarbon, when corrosive media encounter the lateral interface during corrosion of the coating, the corrosion may develop laterally, so that longitudinal corrosion which penetrates the coating is not prone to forming, thereby avoiding the corrosive media from penetrating through the coating and corroding protected materials and devices. Meanwhile, due to the superlattice effect of the modulation nano-layered structure, the accumulation of dislocations between the layers makes the coating less prone to breakdown, and the power-on capability under water resistance is effectively improved.
5. The present invention adopts plasma chemical vapor deposition to control the monomer and the coating structure, to obtain a nano-protective coating with a modulation structure. This coating has the following advantages: each period is composed of a nano-level low-dipole moment layer and a nano-level organic silicon coating or an organic fluorocarbon coating. The total thickness of the coating can be controlled between 20 nm and 10 µm; the hardness can be controlled between HB and 4H; at the same time, it has excellent insulation performance, good power-on capability under water resistance and lower surface energy; and it has excellent three-anti performance.
6. Compared with the ordinary single-time long-term coating, the binding force and compactness of the coating obtained by the method of the present invention are increased by at least 40% to 50% and 35% to 50%, respectively, and the power-on capability under water resistance is increased by 40% to 50%. The modulation structure coating obtained by the cyclic periodic alternating discharge has excellent performance and strong practicability.
7. For general plasma polymerization, a monofunctional hydrocarbon organic compound monomer is selected to obtain a coating with a certain cross-linked structure. The cross-linked structure is formed by the cross-linking of a plurality of active sites formed by chain breakage of the monomer during plasma discharge. However, this cross-linked structure is relatively loose, contains more linear components, and has poor resistance to solution penetration and poor solubility. Compared to traditional monofunctional organic monomers, under plasma conditions, the functional groups connected to silicon in the organic silicon monomer can undergo condensation reactions with each other. Therefore, three-dimensional network cross-linking can occur between the monomers and the monomers, and the compactness, wear resistance and corrosion resistance of the coating can be further improved. The hardness of the organic silicon coating of the same thickness is 1-2 grades higher than that of the traditional coating, and the salt mist resistance is increased by 30-50%.

Electronic equipment in daily life is extremely susceptible to corrosion and damaged by the corrosive environment. It is basically in a corrosive environment during use. In the long run, it will cause damage to electronic equipment such as short circuits and open circuits. The coating method of the present invention greatly increases the great significance of the nanometer in improving the actual production efficiency. The service life of the coating in the corrosive environment is improved, and the protection effect of the product is improved. It is mainly applied in the following products:
(1) Portable device keyboard: the portable keyboard is small and light, and is commonly used in computers, mobile phones and other equipment. It can be convenient for users to work on the journey. However, when it encounters the contamination of common liquids, such as the accidental overturning of the water cup, and the infiltration of rain and sweat, the interior of the keyboard is easily short-circuited and then damaged. By coating this type of nano-coating on the keyboard, it can be ensured that the keyboard surface is easy to clean, and the function is intact when it encounters water, so that the keyboard can adapt to more severe environments.
(2) LED display: a LED display can be used for product promotion, store decoration, lighting and warning. Sometimes, it should be used in harsh environment, such as in a rainy or dusty environment. For example, outdoor LED advertising screens, pavement warning lights, and LED display control panels in the production workshop may have malfunction due to these harsh environments, and are easy to accumulate dust but difficult to clean. After using the nano-coating, the above problems can be effectively solved.
(3) Intelligent fingerprint lock: the fingerprint lock is a smart lock, which integrates computer information technology, electronic technology, mechanical technology and modern hardware technology, and is widely used in public security criminal investigation and judicial fields. However, after encountering water, its internal lines are easily short-circuited and difficult to repair, and the lock has to be violently disassembled. After using the coating, this problem can be avoided.
(4) Hearing aids and Bluetooth headsets: there are no communication cables for hearing aids and Bluetooth headsets. After using the coating, the users can use them in a water environment for a certain period of time, such as bathing and rainy days, and the equipment will not be damaged due to rain infiltration.
(5) Some sensors: some sensors need to operate in a liquid environment, such as water pressure sensors and oil pressure sensors, and sensors used in underwater operating equipment, as well as sensors that often encounter water in the operating environment. After using the coating, it can be ensured that these sensors will not fail due to the liquid invading the internal structure of the mechanical equipment.
(6) Most 3C products: for example, mobile phones, notebooks, PlayStation Portable (PSP), etc.
(7) Other equipment that needs to be waterproof: including equipment that needs to operate in a humid environment, or may encounter accidents such as common liquid spills, which will affect the normal operation of the internal weak current line.

The organic silicon nano-coating prepared by the method can also be applied to the following different environments and related products involved:
Water resistance, moisture resistance and mold resistance:
1 House interior: bathroom top, wallpaper, chandeliers, curtains, and window screens. 2 Daily necessities: mosquito nets, lampshades, chopstick baskets, and automobile rearview mirrors. 3 Cultural relics and artworks: copybooks, antiques, wood carvings, leather, bronzes, silk, ancient costumes, and ancient books. 4 Electronic components and electronic products: sensors (operating in wet or dusty environments), chips of various electronic products (electronic sphygmomanometers, smart watches), circuit boards, mobile phones, LED screens, and hearing aids. 5 Precision instruments and optical equipment: mechanical watches, and microscopes.

Acidic or alkaline solvent resistance, acidic or alkaline salt mist resistance, and acidic atmospheric resistance:
1 Housing interior decorations: wallpaper, and tile. 2 Protective appliances: acid (alkali) resistant gloves, and acid (alkali) resistant protective clothing. 3 Mechanical equipment and pipelines: flue gas desulfurization equipment, seals (acidic/alkaline lubricating oil), pipelines, valves, liners for large-diameter marine transportation pipelines, etc. 4 Various reaction kettles and reactors. 5 Chemical production and storage; sewage treatment, and aeration tanks; 6 Others: acid-alkali workshops, anti-alkali aerospace, energy and power, steel metallurgy, petrochemicals, medical and other industries, storage containers, statues (reducing corrosion of the acid rain on them), and sensors (in an acidic/alkaline environment).

Organic solvent immersion resistance, cosmetics resistance, and sweat resistance:
1 for example, alkanes, olefins, alcohols, aldehydes, amines, esters, ethers, ketones, aromatic hydrocarbons, hydrogenated hydrocarbons, terpene olefins, halogenated hydrocarbons, heterocyclic compounds, nitrogen-containing compounds, sulfur-containing compounds and other solvents; 2 Cosmetic packaging containers; 3 Fingerprint locks, and headsets.

Cold and heat cycle impact (-40°C to + 75°C) resistance, and wet and heat alternating (humidity 75% to 95%) resistance: electrotechnics, electronics, and automotive appliances, such as equipment in the fields of aviation, automobile, home appliances, scientific research and so on.

### Detailed Description of the Embodiments

The present invention is described in detail below with reference to specific embodiments, but the present invention is not limited to the specific embodiments.

### Embodiment 1

A method for preparing a highly insulating nano-protective coating with a modulation structure, including the following steps:
(1) Pre-treatment: A base material is placed in a reaction chamber of nano-coating preparation equipment, the reaction chamber is closed and the reaction chamber is continuously vacuumized so that the degree of vacuum in the reaction chamber is vacuumized to 10 mTorr, the inert gas Ar is introduced, and a movement mechanism is turned on to make the base material move in the reaction chamber.

In step (1), the base material is a solid material, the solid material is a block aluminum material and a PCB, and after the surface of the base material is prepared with a cold and heat cycle impact resistant coating, any interface thereof can be exposed to a cold and heat cycle test environment.

In step (1), the reaction chamber is a rotating body-shaped chamber, the volume of the reaction chamber is 50 L, the temperature of the reaction chamber is controlled at 30°C, and the flow rate of the introduced inert gas is 5 sccm.

In step (1), the base material moves in the reaction chamber, and a form of movement of the base material is that the base material is moved in a circular motion relative to the reaction chamber at a rotation speed of 10 rpm.

### (2) Preparation of the highly insulating nano-coating:

The following steps are performed 12 times to prepare a nano-coating with a high insulation modulation structure on the surface of the base material:
monomer A vapor is introduced into the reaction chamber to the degree of vacuum of 40 mTorr, plasma discharge is turned on to perform chemical vapor deposition, the introduction of monomer A vapor is stopped, monomer B vapor is introduced, the plasma discharge is continued to perform chemical vapor deposition, and the introduction of the monomer B vapor is stopped;
the composition of the monomer A vapor includes:
   a mixture of one low-dipole moment organic monomer and two unsaturated hydrocarbons, polyfunctional unsaturated hydrocarbons and hydrocarbon derivatives, wherein a mass fraction of the unsaturated hydrocarbons, polyfunctional unsaturated hydrocarbons and hydrocarbon derivatives in the monomer A vapor is 15%;
   the one low-dipole moment organic monomer is: 1,8-diiodoperfluorooctane,
   the two unsaturated hydrocarbons, polyfunctional unsaturated hydrocarbons and hydrocarbon derivatives are: 1,3-butadiene, and ethoxylated trimethylolpropane triacrylate;
the composition of the monomer B vapor includes:
   a mixture of one monofunctional unsaturated fluorocarbon resin and three unsaturated hydrocarbons, polyfunctional unsaturated hydrocarbons and hydrocarbon derivatives, wherein a mass fraction of the unsaturated hydrocarbons, polyfunctional unsaturated hydrocarbons and hydrocarbon derivatives in the monomer B vapor is 65%;
   the one monofunctional unsaturated fluorocarbon resin is: 2-(perfluorododecyl) ethyl acrylate;
   the three unsaturated hydrocarbons, polyfunctional unsaturated hydrocarbons and hydrocarbon derivatives are: 1,4-pentadiene, tripropylene glycol diacrylate, and 1,6-hexanediol diacrylate;
   the introducing the monomer A vapor and the monomer B vapor is to atomize and volatilize the monomers through a feed pump and introduce them into the reaction chamber under a low pressure of 10 mTorr, and the flow rates of introducing the monomer A and the monomer B each are 10 µL/min; and
   in the step (2), the monomer A vapor or the monomer B vapor is introduced, and the plasma discharge is carried out to perform chemical vapor deposition, and in the deposition process, the plasma discharge process is a low-power continuous discharge, specifically including the following deposition process once:
      the deposition process includes a pre-treatment stage and a coating stage, in the pre-treatment stage, plasma discharge power is 150 W, continuous discharge time is 450 s, and then it enters the coating stage, in which the plasma discharge power is adjusted to 10 W, and the continuous discharge time is 3600 s.

In the step (2), the mode of the plasma discharge is radio-frequency discharge.

### (3) Post-treatment:

The plasma discharge is stopped, and the vacuumization is continued to maintain the degree of vacuum of the reaction chamber at 10 mTorr. After 1 min, the air is introduced to one atmospheric pressure, and then the base material is taken out.

The dielectric constant of the coating obtained by the above process is 2.73. The cold and heat cycle impact test results of the coated aluminum material and PCB are as follows:

| Test base material | Experimental condition | | Number of cycles | Experimental time | Detection of results |
|---|---|---|---|---|---|
| Aluminum material | | -40□∼+75□ | 25 | 2 h | No effect on appearance |
| | | -40°C to 75°C | | | Good performance |
| PCB | | -40□∼75□ | 25 | 2h | No effect on appearance |
| | | -40°C to +75°C | | | Good performance |

The wet and heat alternating test results of the above coated aluminum material are as follows:
Temperature : 55 °C

| Experimental condition | Temperature | | 55□ | | | | |
|---|---|---|---|---|---|---|---|
| | Humidity | | 75% | 80% | 85% | 90% | 95% |
| Aluminum material | Time | 12 h | Pass | Pass | Pass | Pass | Pass |
| | Time | 24 h | Pass | Pass | Pass | Pass | Pass |
| | Time | 36 h | Pass | Pass | Pass | Pass | Pass |
| | Time | 48 h | Pass | Pass | Pass | Pass | Pass |

### Embodiment 2

A method for preparing a highly insulating nano-protective coating with a modulation structure, including the following steps:
(1) A base material is placed in a reaction chamber of nano-coating preparation equipment, the reaction chamber is closed and the reaction chamber is continuously vacuumized so that the degree of vacuum in the reaction chamber is vacuumized to 30 mTorr, the inert gas He is introduced, and a movement mechanism is turned on to make the base material move.

In the step (1), the base material is a solid material, the solid material is a block aluminum material, and after the surface of the base material is prepared with a wet and heat alternating resistant coating, any interface thereof can be exposed to a wet and heat test environment.

In the step (1), the reaction chamber is a cube-shaped chamber, the volume of the reaction chamber is 270 L, the temperature of the reaction chamber is controlled at 42°C, and the flow rate of the introduced inert gas is 18 sccm.

In the step (1), the base material performs planetary motion with the revolution speed of 4 rpm and the rotation speed of 10 rpm.

### (2) Preparation of the highly insulating nano-coating:

The following steps are performed once to prepare a nano-coating with a high insulation modulation structure on the surface of the base material:
monomer A vapor is introduced into the reaction chamber to the degree of vacuum of 70 mTorr, plasma discharge is turned on to perform chemical vapor deposition, the introduction of monomer A vapor is stopped, monomer C vapor is introduced, the plasma discharge is continued to perform chemical vapor deposition, and the introduction of the monomer C vapor is stopped;
the composition of the monomer A vapor incldes:
   a mixture of three low-dipole moment organic monomers and one unsaturated hydrocarbon, polyfunctional unsaturated hydrocarbon and hydrocarbon derivative, wherein a mass fraction of the unsaturated hydrocarbon, polyfunctional unsaturated hydrocarbon and hydrocarbon derivative in the monomer A vapor is 29%;
   the three low-dipole moment organic monomers are: polydimethylsiloxane with the molecular weight of 50,000, decafluorobenzophenone, and hexafluoropropylene;
   the one unsaturated hydrocarbon, polyfunctional unsaturated hydrocarbon and hydrocarbon derivative is: ethylene glycol diacrylate;
the composition of the monomer C vapor includes:
   a mixture of one organic silicon monomer including a double-bond structure and four unsaturated hydrocarbons, polyfunctional unsaturated hydrocarbons and hydrocarbon derivatives, wherein a mass fraction of the unsaturated hydrocarbons, polyfunctional unsaturated hydrocarbons and hydrocarbon derivatives in the monomer C vapor is 32%;
   the one organic silicon monomer including the double-bond structure is: vinyl tributanone oxime silane,
   the four unsaturated hydrocarbons, polyfunctional unsaturated hydrocarbons and hydrocarbon derivatives are: isoprene, 1,4-pentadiene, tripropylene glycol diacrylate, and diethylene glycol divinyl ether;
   the introducing the monomer A vapor and the monomer C vapor is to atomize and volatilize the monomers through a feed pump and introduce them into the reaction chamber under a low pressure of 30 mTorr, and the flow rates of introducing the monomer A and the monomer C each are 85 µL/min; and
   in the step (2), the monomer A vapor or the monomer C vapor is introduced, and the plasma discharge is carried out to perform chemical vapor deposition, and in the deposition process, the plasma discharge process is a low-power continuous discharge, specifically including the following deposition process five times:
      the deposition process includes a pre-treatment stage and a coating stage, in the pre-treatment stage, the plasma discharge power is 600 W, the continuous discharge time is 60 s, and then it enters the coating stage, in which the plasma discharge power is adjusted to 150 W, and the continuous discharge time is 600 s.

In the step (2), the mode of the plasma discharge is microwave discharge.

### (3) Post-treatment:

The plasma discharge is stopped, and the vacuumization is continued to maintain the degree of vacuum of the reaction chamber at 60 mTorr. After 2 min, the air is introduced to one atmospheric pressure, and then the base material is taken out.

The dielectric constant of the coating obtained by the above process is 2.45. The cold and heat cycle impact test results of the coated aluminum material are as follows:

| Test base material | Experimental condition | | Number of cycles | Experimental time | Detection of results |
|---|---|---|---|---|---|
| Aluminum base material | | -40□∼+75□ | 25 | 2 h | No effect on appearance |
| | | -40°C to +75 °C | | | Good performance |

The wet and heat alternating test results of the above coated aluminum material are as follows: temperature 55°C

| Experimental condition | Temperature | | 55□ | | | | |
|---|---|---|---|---|---|---|---|
| | Humidity | | 75% | 80% | 85% | 90% | 95% |
| Aluminum material | Time | 12 h | Pass | Pass | Pass | Pass | Pass |
| | Time | 24 h | Pass | Pass | Pass | Pass | Pass |
| | Time | 36 h | Pass | Pass | Pass | Pass | Pass |
| | Time | 48 h | Pass | Pass | Pass | Pass | Pass |

### Embodiment 3

A method for preparing a highly insulating nano-protective coating with a modulation structure, including the following steps:
(1) A base material is placed in a reaction chamber of nano-coating preparation equipment, the reaction chamber is closed and the reaction chamber is continuously vacuumized so that the degree of vacuum in the reaction chamber is vacuumized to 80 mTorr, the mixed gas of inert gases He and Ar is introduced, and a movement mechanism is turned on to make the base material move.

In the step (1), the base material is a solid material, the solid material is a block polytetrafluoroethylene plate and an electrical component, and after the surface of the block polytetrafluoroethylene plate is prepared with an anti-mold coating, any interface thereof can be exposed to a GJB 150. 10A-2009 mold test environment for use, and after the surface of the electrical component is prepared with a waterproof and electrical breakdown resistant coating, any interface thereof can be exposed to an environment described in the international industrial waterproof grade standard IPX7 for use.

In the step (1), the reaction chamber is a rotating body-shaped chamber, the volume of the reaction chamber is 580 L, the temperature of the reaction chamber is controlled at 53°C, and the flow rate of the introduced inert gas is 65 sccm.

In the step (1), the base material is moved in a circular motion at a rotation speed of 12 rpm.

### (2) Preparation of the highly insulating nano-coating:

The following steps are performed 8 times to prepare a nano-coating with a high insulation modulation structure on the surface of the base material:
monomer A vapor is introduced into the reaction chamber to the degree of vacuum of 120 mTorr, plasma discharge is turned on to perform chemical vapor deposition, the introduction of monomer A vapor is stopped, monomer C vapor is introduced, the plasma discharge is continued to perform chemical vapor deposition, and the introduction of the monomer C vapor is stopped;
the composition of the monomer A vapor includes:
   a mixture of four low-dipole moment organic monomers and two unsaturated hydrocarbons, polyfunctional unsaturated hydrocarbons and hydrocarbon derivatives, wherein a mass fraction of the unsaturated hydrocarbons, polyfunctional unsaturated hydrocarbons and hydrocarbon derivatives in the monomer A vapor is 48%;
   the four low-dipole moment organic monomers are: toluene, α-methylstyrene, dimethylsiloxane, and decafluorobenzophenone,
   the two unsaturated hydrocarbons, polyfunctional unsaturated hydrocarbons and hydrocarbon derivatives are: isoprene, and neopentyl glycol diacrylate;
   the composition of the monomer C vapor includes:
      a mixture of five organic silicon monomers including a Si-Cl structure and two unsaturated hydrocarbons, polyfunctional unsaturated hydrocarbons and hydrocarbon derivatives, wherein a mass fraction of the unsaturated hydrocarbons, polyfunctional unsaturated hydrocarbons and hydrocarbon derivatives in the monomer C vapor is 52%;
      the five organic silicon monomers including the Si-Cl structure are: triphenylchlorosilane, trifluoropropylmethyldichlorosilane, dimethylphenylchlorosilane, tributylchlorosilane, and benzyldimethyl chlorochlorosilane,
      the two unsaturated hydrocarbons, polyfunctional unsaturated hydrocarbons and hydrocarbon derivatives are: polyethylene glycol diacrylate, and 1,6-hexanediol diacrylate;
      the introducing the monomer A vapor and the monomer C vapor is to atomize and volatilize the monomers through a feed pump and introduce them into the reaction chamber under a low pressure of 80 mTorr, and the flow rates of introducing the monomer A and the monomer C each are 440 µL/min; and
      in the step (2), the monomer A vapor or the monomer C vapor is introduced, and the plasma discharge is carried out to perform chemical vapor deposition, and in the deposition process, the plasma discharge process is pulse discharge, specifically including the following deposition process once:
         the deposition process includes a pre-treatment stage and a coating stage, in the pre-treatment stage, the plasma discharge power is 150 W, the continuous discharge time is 450 s, then it enters the coating stage, and the coating stage is pulse discharge, in which the power is 10 W, the time is 3600 s, the frequency of pulse discharge is 1 HZ, and the duty cycle of pulse is 1:500.

In the step (2), the mode of the plasma discharge is electric spark discharge.

### (3) Post-treatment:

The plasma discharge is stopped, and the vacuumization is continued to maintain the degree of vacuum of the reaction chamber at 100 mTorr. After 3 min, the air is introduced to one atmospheric pressure, and then the base material is taken out.

The dielectric constant of the coating obtained by the above process is 2.46. After the polytetrafluoroethylene plate is coated, the GJB150.10A-2009 mold test results are as follows:

| Polytetrafluoroethylene plate-performance test | |
|---|---|
| Water contact angle | 121° |
| Oil contact angle | 95° |
| Anti-mold level | 2-level |
| Degree of surface mold spots | 6% |

Experimental results of an underwater immersion test for the electrical component prepared with the waterproof and electrical breakdown resistant coating under different voltages:

| Power-on capability under water resistance | | | |
|---|---|---|---|
| | Time used for the current to reach 1 mA at a certain voltage | | |
| | 3.8 V | 5 V | 12.5 V |
| Embodiment 3 | >96 h | >96 h | >96 h |

Results of an IPX 7 waterproof rating test (1 m-underwater immersion test for 30 min):

| IPX 7 waterproof rating test | |
|---|---|
| Embodiment 3 | Electrical component works normally |

### Embodiment 4

A method for preparing a highly insulating nano-protective coating with a modulation structure, including the following steps:
(1) A base material is placed in a reaction chamber of nano-coating preparation equipment, the reaction chamber is closed and the reaction chamber is continuously vacuumized so that the degree of vacuum in the reaction chamber is vacuumized to 100 mTorr, the inert gas Ar is introduced, and a movement mechanism is turned on to make the base material move.

In the step (1), the base material is a solid material, the solid material is a block polytetrafluoroethylene plate and an electrical component, and after the surface of the block polytetrafluoroethylene plate is prepared with an anti-mold coating, any interface thereof can be exposed to a GJB 150. 10A-2009 mold test environment for use, and after the surface of the electrical component is prepared with a waterproof and electrical breakdown resistant coating, any interface thereof can be exposed to an environment described in the international industrial waterproof grade standard IPX7 for use.

In the step (1), the volume of the reaction chamber is 640 L, the temperature of the reaction chamber is controlled at 54°C, and the flow rate of the inert gas is 240 sccm.

In the step (1), the base material is moved in a linear reciprocating motion at a movement speed of 23 mm/min.

### (2) Preparation of the highly insulating nano-coating:

The following steps are performed 15 times to prepare a nano-coating with a high insulation modulation structure on the surface of the base material:
monomer A vapor is introduced into the reaction chamber to the degree of vacuum of 150 mTorr, plasma discharge is turned on to perform chemical vapor deposition, the introduction of monomer A vapor is stopped, monomer B vapor is introduced, the plasma discharge is continued to perform chemical vapor deposition, and the introduction of the monomer B vapor is stopped;
the composition of the monomer A vapor includes:
   a mixture of five low-dipole moment organic monomers and three unsaturated hydrocarbons, polyfunctional unsaturated hydrocarbons and hydrocarbon derivatives, wherein a mass fraction of the unsaturated hydrocarbons, polyfunctional unsaturated hydrocarbons and hydrocarbon derivatives in the monomer A vapor is 65%;
   the five low-dipole moment organic monomers are: para-xylene, 1H,1H-perfluorooctylamine, 2-(perfluorooctyl)ethyl methacrylate, 1,1,2,2-tetrahydroperfluorohexyl iodine, and 2,4,6-tris(perfluoroheptyl)-1,3,5-triazine,
   the three unsaturated hydrocarbons, polyfunctional unsaturated hydrocarbons and hydrocarbon derivatives are: isoprene, tripropylene glycol diacrylate, and polyethylene glycol diacrylate;
the composition of the monomer B vapor includes:
   a mixture of four monofunctional unsaturated fluorocarbon resin and four unsaturated hydrocarbons, polyfunctional unsaturated hydrocarbons and hydrocarbon derivatives, wherein a mass fraction of the unsaturated hydrocarbons, polyfunctional unsaturated hydrocarbons and hydrocarbon derivatives in the monomer B vapor is 15%;
   the four monofunctional unsaturated fluorocarbon resins are: 2-(perfluorobutyl)ethyl acrylate, (perfluorocyclohexyl)methacrylate, 3,3,3-trifluoro-1-propyne, and 4-ethynyltrifluorotoluene,
   the four unsaturated hydrocarbons, polyfunctional unsaturated hydrocarbons and hydrocarbon derivatives are: isoprene, 1,4-pentadiene, polyethylene glycol diacrylate, and 1,6-hexanediol diacrylate;
   the introducing the monomer A vapor and the monomer B vapor is to atomize and volatilize the monomers through a feed pump and introduce them into the reaction chamber under a low pressure of 100 mTorr, and the flow rates of introducing the monomer A and the monomer B each are 1000 µL/min; and
   in the step (2), the monomer A vapor or the monomer B vapor is introduced, and the plasma discharge is carried out to perform chemical vapor deposition, and in the deposition process, the plasma discharge process is pulse discharge, specifically including the following deposition process 7 times:
      the deposition process includes a pre-treatment stage and a coating stage, in the pre-treatment stage, the plasma discharge power is 600 W, the continuous discharge time is 60 s, then it enters the coating stage, and the coating stage is pulse discharge, in which the power is 300 W, the time is 600 s, the frequency of pulse discharge is 1000 HZ, and the duty cycle of pulse is 1:1.

In the step (2), the mode of the plasma discharge is high-frequency discharge, and the waveform of the high-frequency discharge is sinusoidal.

### (3) Post-treatment:

The introduction of the monomer vapor is stopped while the phase discharge is stopped, and the vacuumization is continued to maintain the degree of vacuum of the reaction chamber at 200 mTorr. After 4 min, the air is introduced to one atmospheric pressure, and then the base material is taken out.

The dielectric constant of the coating obtained by the above process is 2.48. After the polytetrafluoroethylene plate is coated, the GJB150.10A-2009 mold test results are as follows:

| Polytetrafluoroethylene plate-performance test | |
|---|---|
| Water contact angle | 126° |
| Oil contact angle | 98° |
| Anti-mold level | 2-level |
| Degree of surface mold spots | 7% |

Experimental results of an underwater immersion test for the electrical component prepared with the waterproof and electrical breakdown resistant coating under different voltages:

| Power-on capability under water resistance | | | |
|---|---|---|---|
| | Time used for the current to reach 1 mA at a certain voltage | | |
| | 3.8 V | 5 V | 12.5 V |
| Embodiment 4 | >96 h | >96 h | >96 h |

Results of an IPX 7 waterproof rating test (1 m-underwater immersion test for 30 min):

| IPX 7 waterproof rating test | |
|---|---|
| Embodiment 4 | Electrical member works normally |

### Embodiment 5

A method for preparing a highly insulating nano-protective coating with a modulation structure, including the following steps:
(1) A base material is placed in a reaction chamber of nano-coating preparation equipment, the reaction chamber is closed and the reaction chamber is continuously vacuumized so that the degree of vacuum in the reaction chamber is vacuumized to 200 mTorr, the mixed gas of inert gases He and Ar is introduced, and a movement mechanism is turned on to make the base material move.

In the step (1), the base material is a solid material, the solid material is a block aluminum material, and after the surface of the base material is prepared with an acidic or alkaline environment resistant coating, any interface thereof can be exposed to an acid or alkali test environment.

In the step (1), the volume of the reaction chamber is 1000 L, the temperature of the reaction chamber is controlled at 60°C, and the flow rate of the inert gas is 300 sccm.

In the step (1), the base material is moved in a curvilinear reciprocating motion at a speed of 50 mm/min.

### (2) Preparation of the highly insulating nano-coating:

The following steps are performed 26 times to prepare a nano-coating with a high insulation modulation structure on the surface of the base material:
monomer A vapor is introduced into the reaction chamber to the degree of vacuum of 300 mTorr, plasma discharge is turned on to perform chemical vapor deposition, the introduction of monomer A vapor is stopped, monomer C vapor is introduced, the plasma discharge is continued to perform chemical vapor deposition, and the introduction of the monomer C vapor is stopped;
the composition of the monomer A vapor includes:
   a mixture of six low-dipole moment organic monomers and three unsaturated hydrocarbons, polyfunctional unsaturated hydrocarbons and hydrocarbon derivatives, wherein a mass fraction of the unsaturated hydrocarbons, polyfunctional unsaturated hydrocarbons and hydrocarbon derivatives in the monomer A vapor is 56%;
   the six low-dipole moment organic monomers are: benzene, α-methylstyrene, dimethylsiloxane, allylbenzene, 2-(perfluorobutyl)ethyl methacrylate, and 1,1,2,2-tetrahydroperfluorohexyl iodine,
   the three unsaturated hydrocarbons, polyfunctional unsaturated hydrocarbons and hydrocarbon derivatives are: 1,4-pentadiene, polyethylene glycol diacrylate, and 1,6-hexanediol diacrylate;
the composition of the monomer C vapor includes:
   a mixture of four organic silicon monomers including a Si-O-C structure and three unsaturated hydrocarbons, polyfunctional unsaturated hydrocarbons and hydrocarbon derivatives, wherein a mass fraction of the unsaturated hydrocarbons, polyfunctional unsaturated hydrocarbons and hydrocarbon derivatives in the monomer C vapor is 65%;
   the four organic silicon monomers including the Si-O-C structure are: trimethoxyhydrosiloxane, n-octyltriethoxysilane, triethylvinylsilane, and 3-(methacryloyloxy)propane trimethoxysilane,
   the three unsaturated hydrocarbons, polyfunctional unsaturated hydrocarbons and hydrocarbon derivatives are: 1,4-pentadiene, ethoxylated trimethylolpropane triacrylate, and polyethylene glycol diacrylate;
   the introducing the monomer A vapor and the monomer C vapor is to atomize and volatilize the monomers through a feed pump and introduce them into the reaction chamber under a low pressure of 200 mTorr, and the flow rates of introducing the monomer A and the monomer C each are 780 µL/min; and
   in the step (2), the monomer A vapor or the monomer C vapor is introduced, and the plasma discharge is carried out to perform chemical vapor deposition, and in the deposition process, the plasma discharge process is periodic alternate discharge, specifically including the following deposition process once:
      the deposition process includes a pre-treatment stage and a coating stage, in the pre-treatment stage, plasma discharge power is 150 W, continuous discharge time is 450 s, and then it enters the coating stage, in which the plasma is a periodic alternating discharge output, the power is 10 W, the time is 3600 s, the alternating frequency is 1 Hz, and the waveform of the periodic alternating discharge output of the plasma is a sawtooth waveform.

In the step (2), the mode of the plasma discharge is an intermediate-frequency discharge, and the waveform of the intermediate-frequency discharge is a bipolar pulse.

### (3) Post-treatment:

The plasma discharge is stopped, and the reaction chamber is aerated with the air to the pressure of 2000 mTorr, and then is vacuumized to 10 mTorr. The above aeration and vacuumization steps are performed ten times, the air is introduced to one atmospheric pressure, the movement of the base material is stopped, and then the base material is taken out. The rest results of the coating and the coated aluminum material obtained by the above process are as follows:

| Performance | | | | |
|---|---|---|---|---|
| | Water contact angle | Oil contact angle | Adhesion | Dielectric constant |
| Embodiment 5 | 125° | 84° | Low adhesion, water droplets easily slip off | 2.57 |

### (2) Test results for resistance to organic solvents: (pass means that the contact angle changes less than 5° after immersing for a period of time)

| Base material | Chemical reagent | Time | | | |
|---|---|---|---|---|---|
| | | 48 h | 96 h | 144 h | 192 h |
| aluminum sheet | acetone | pass | pass | pass | pass |
| | cyclohexane | pass | pass | pass | pass |
| | petroleum ether | pass | pass | pass | pass |
| | xylene | pass | pass | pass | pass |
| | n-propanol | pass | pass | pass | pass |

### (3) Acid and alkali test results: (pass means that no corrosion phenomenon occurs after performing the experiment for a period of time)

| Base material | Acid or alkali reagent | Time | | | |
|---|---|---|---|---|---|
| | | 48 h | 96 h | 144 h | 192 h |
| aluminum sheet | Acidic salt mist | pass | pass | pass | pass |
| | Neutral salt mist | pass | pass | pass | pass |
| | Alkaline salt mist | pass | pass | pass | pass |
| | 5% acetic acid solution | pass | pass | pass | pass |
| | 5% NaOH solution | pass | pass | pass | pass |

### Embodiment 6

A method for preparing a highly insulating nano-protective coating with a modulation structure, including the following steps:
(1) A base material is placed in a reaction chamber of nano-coating preparation equipment, the reaction chamber is closed and the reaction chamber is continuously vacuumized so that the degree of vacuum in the reaction chamber is vacuumized to 160 mTorr, the inert gas Ar is introduced, and a movement mechanism is turned on to make the base material move.

In the step (1), the base material is a solid material, the solid material is a block aluminum material and an electrical component, and after the surface of the base material is prepared with a highly insulating coating, any interface thereof can be exposed to an organic solvent test environment.

In the step (1), the volume of the reaction chamber is 400 L, the temperature of the reaction chamber is controlled at 40°C, and the flow rate of the inert gas is 150 sccm.

In the step (1), the base material is moved in a curvilinear reciprocating motion at a speed of 30 mm/min.

### (2) Preparation of the highly insulating nano-coating:

The following steps are performed 35 times to prepare a nano-coating with a high insulation modulation structure on the surface of the base material:
monomer A vapor is introduced into the reaction chamber to the degree of vacuum of 230 mTorr, plasma discharge is turned on to perform chemical vapor deposition, the introduction of monomer A vapor is stopped, monomer C vapor is introduced, the plasma discharge is continued to perform chemical vapor deposition, and the introduction of the monomer C vapor is stopped;
the composition of the monomer A vapor includes:
   a mixture of five low-dipole moment organic monomers and four unsaturated hydrocarbons, polyfunctional unsaturated hydrocarbons and hydrocarbon derivatives, wherein a mass fraction of the unsaturated hydrocarbons, polyfunctional unsaturated hydrocarbons and hydrocarbon derivatives in the monomer A vapor is 65%;
   the five low-dipole-moment organic monomers are: allylbenzene, decafluorobenzophenone, hexafluoropropylene, 1H,1H-perfluorooctylamine, and perfluorooctyliodoane,
   the four unsaturated hydrocarbons, polyfunctional unsaturated hydrocarbons and hydrocarbon derivatives are: 1,4-pentadiene, ethoxylated trimethylolpropane triacrylate, polyethylene glycol diacrylate, and 1,6- hexanediol diacrylate;
the composition of the monomer C vapor includes:
   a mixture of six organic silicon monomers including a cyclic structure and four unsaturated hydrocarbons, polyfunctional unsaturated hydrocarbons and hydrocarbon derivatives, wherein a mass fraction of the unsaturated hydrocarbons, polyfunctional unsaturated hydrocarbons and hydrocarbon derivatives in the monomer C vapor is 40%;
   the six organic silicon monomers including the cyclic structure are: hexaphenylcyclotrisiloxane, octaphenylcyclotetrasiloxane, diphenyldihydroxysilane, bis(tritylsilyl)chromate, trifluoropropylmethylcyclotrisiloxane, and 2,2,4,4-tetramethyl-6,6,8,8-tetraphenylcyclotetrasiloxane,
   the four unsaturated hydrocarbons, polyfunctional unsaturated hydrocarbons and hydrocarbon derivatives are: 1,3-butadiene, isoprene, ethoxylated trimethylolpropane triacrylate, and ethylene glycol diacrylate;
   the introducing the monomer A vapor and the monomer C vapor is to atomize and volatilize the monomers through a feed pump and introduce them into the reaction chamber under a low pressure of 160 mTorr, and the flow rates of introducing the monomer A and the monomer C each are 460 µL/min; and
   in the step (2), the monomer A vapor or the monomer C vapor is introduced, and the plasma discharge is carried out to perform chemical vapor deposition, and in the deposition process, the plasma discharge process is periodic alternate discharge, specifically including the following deposition process five times:
      the deposition process includes a pre-treatment stage and a coating stage, in the pre-treatment stage, plasma discharge power is 600 W, continuous discharge time is 60 s, and then it enters the coating stage, in which the plasma is a periodic alternating discharge output, the power is 300 W, the time is 600 s, the alternating frequency is 1000 Hz, and the waveform of the periodic alternating discharge output of the plasma is a half-wave rectified waveform.

In the step (2), the mode of the plasma discharge is microwave discharge.

### (3) Post-treatment:

The plasma discharge is stopped, the reaction chamber is aerated with the inert gas to the pressure of 5000 mTorr, and then is vacuumized to 200 mTorr. The above aeration and vacuumization steps are performed once, the air is introduced to one atmospheric pressure, the movement of the base material is stopped, and then the base material is taken out.

The test results of the above coated aluminum material are as follows:
(1) Hydrophobic and oleophobic properties

| Performance | | | | |
|---|---|---|---|---|
| | Water contact angle | Oil contact angle | Adhesion | Dielectric constant |
| Embodiment 6 | 120° | 80° | Low adhesion, water droplets easily slip off | 2.46 |

(2) Experimental results of an underwater immersion test of the above coated electrical component under different voltages:

| Power-on capability under water resistance | | | |
|---|---|---|---|
| | Time used for the current to reach 1 mA at a certain voltage | | |
| | 3.8 V | 5 V | 12.5 V |
| Embodiment 6 | >120 h | > 120 h | > 120 h |

(3) Test results for resistance to organic solvents: (pass means that the contact angle changes less than 5° after immersing for a period of time)

| Base material | Chemical reagent | Time | | | |
|---|---|---|---|---|---|
| | | 48 h | 96 h | 144 h | 192 h |
| Aluminum material | acetone | pass | pass | pass | pass |
| | cyclohexane | pass | pass | pass | pass |
| | petroleum ether | pass | pass | pass | pass |
| | xylene | pass | pass | pass | pass |
| | n-propanol | pass | pass | pass | pass |

(4) Acid and alkali test results: (pass means that no corrosion phenomenon occurs after performing the experiment for a period of time)

| Base material | Acid or alkali reagent | Time | | | |
|---|---|---|---|---|---|
| | | 48 h | 96 h | 144 h | 192 h |
| Aluminum material | Acidic salt mist | pass | Pass | pass | pass |
| | Neutral salt mist | pass | Pass | pass | pass |
| | Alkaline salt mist | pass | Pass | pass | pass |
| | 5% acetic acid solution | pass | Pass | pass | pass |
| | 5% NaOH solution | pass | Pass | pass | pass |

| | Water contact angle | Oil contact angle | Adhesion | Dielectric constant | |
|---|---|---|---|---|---|
| Embodiment 6 | 120° | 80° | Low adhesion, water droplets easily slip off | 2.46 | |

### (2) Experimental results of an underwater immersion test of the above coated electrical component under different voltages:

| Power-on capability under water resistance | | | |
|---|---|---|---|
| | Time used for the current to reach 1 mA at a certain voltage | | |
| | 3.8 V | 5 V | 12.5 V |
| Embodiment 6 | >120 h | > 120 h | > 120 h |

### (3) Test results for resistance to organic solvents: (pass means that the contact angle changes less than 5° after immersing for a period of time)

| Base material | Chemical reagent | Time | | | |
|---|---|---|---|---|---|
| | | 48 h | 96 h | 144 h | 192 h |
| Aluminum material | acetone | pass | pass | pass | pass |
| | cyclohexane | pass | pass | pass | pass |
| | petroleum ether | pass | pass | pass | pass |
| | xylene | pass | pass | pass | pass |
| | n-propanol | pass | pass | pass | pass |

### (4) Acid and alkali test results: (pass means that no corrosion phenomenon occurs after performing the experiment for a period of time)

| Base material | Acid or alkali reagent | Time | | | |
|---|---|---|---|---|---|
| | | 48 h | 96 h | 144 h | 192 h |
| Aluminum material | Acidic salt mist | pass | pass | pass | pass |
| | Neutral salt mist | pass | pass | pass | pass |
| | Alkaline salt mist | pass | pass | pass | pass |
| | 5% acetic acid solution | pass | pass | pass | pass |
| | 5% NaOH solution | pass | pass | pass | pass |

## Claims

1. A method for preparing a highly insulating nano-protective coating with a modulation structure, **characterized by** comprising the following steps:
(1) pre-treatment:
placing a base material in a reaction chamber of nano-coating preparation equipment, continuously vacuumizing the reaction chamber so that a degree of vacuum in the reaction chamber is vacuumized to 10 to 200 mTorr, and introducing an inert gas He or Ar or a mixed gas of He and Ar, and turning on a movement mechanism to make the base material move in the reaction chamber;
(2) preparation of the highly insulating nano-coating:
performing the following steps at least once to prepare a nano-coating with a high insulation modulation structure on a surface of the base material:
introducing monomer A vapor into the reaction chamber to the degree of vacuum of 30 to 300 mTorr, turning on plasma discharge to perform chemical vapor deposition, stopping the introduction of monomer A vapor, introducing monomer B or monomer C vapor, continuing the plasma discharge to perform chemical vapor deposition, and stopping the introduction of the monomer B or monomer C vapor;
wherein the composition of the monomer A vapor comprises:
a mixture of at least one low-dipole moment organic compound and at least one unsaturated hydrocarbon, polyfunctional unsaturated hydrocarbon and hydrocarbon derivative, wherein a mass fraction of the unsaturated hydrocarbon, polyfunctional unsaturated hydrocarbon and hydrocarbon derivative in the monomer A vapor is 15% to 65%;
the composition of the monomer B vapor comprises:
a mixture of at least one monofunctional unsaturated fluorocarbon resin and at least one unsaturated hydrocarbon, polyfunctional unsaturated hydrocarbon and hydrocarbon derivative, wherein a mass fraction of the unsaturated hydrocarbon, polyfunctional unsaturated hydrocarbon and hydrocarbon derivative in the monomer B vapor is 15% to 65%;
the composition of the monomer C vapor comprises:
a mixture of at least one organic silicon monomer including a double-bond, Si-Cl, Si-O-C, Si-N-Si, or Si-O-Si structure or a cyclic structure and at least one unsaturated hydrocarbon, polyfunctional unsaturated hydrocarbon and hydrocarbon derivative, wherein a mass fraction of the unsaturated hydrocarbon, polyfunctional unsaturated hydrocarbon and hydrocarbon derivative in the monomer C vapor is 15% to 65%;
flow rates of introducing the monomer A, the monomer B and the monomer C each are 10 to 1000 µL/min; and
(3) post-treatment:
stopping the plasma discharge, continuing to vacuumize to maintain the degree of vacuum of the reaction chamber at 10 to 200 mTorr, after 1 to 5 min, introducing air to an atmospheric pressure, stopping the movement of the base material, and then taking out the base material;
or, stopping the plasma discharge, aerating the reaction chamber with the air or the inert gas to a pressure of 2000 to 5000 mTorr, then vacuumizing to 10 to 200 mTorr, performing the above aeration and vacuumization steps at least once, introducing the air up to atmospheric pressure, stopping the movement of the base material, and then taking out the base material.

2. The method for preparing the highly insulating nano-protective coating with the modulation structure according to claim 1, **characterized in that**: the base material in the step (1) generates a movement in the reaction chamber, a form of the movement of the base material is that the base material performs a linear reciprocating motion or a curvilinear motion relative to the reaction chamber, and the curvilinear motion includes a circular motion, an elliptical motion, a planetary motion, a spherical motion, or curvilinear motions of other irregular routes.

3. The method for preparing the highly insulating nano-protective coating with the modulation structure according to claim 1, **characterized in that**: the base material in the step (1) is a solid material, the solid material is an electronic product, an electrical component, an electronic assembly semi-finished product, a PCB, a metal plate, a polytetrafluoroethylene plate or an electronic component, and after the surface of the base material is prepared with an organosilicon nano-coating, any interface thereof can be exposed to a water environment, a mold environment, and an acidic or alkaline solvent environment, an acidic or alkaline salt mist environment, an acidic atmospheric environment, an organic solvent immersion environment, a cosmetics environment, a sweat environment, a cold and heat cycle impact environment or a wet and heat alternating environment for use.

4. The method for preparing the highly insulating nano-protective coating with the modulation structure according to claim 1, **characterized in that**: the reaction chamber in the step (1) is a cube-shaped chamber with a volume of 50 to 1000 L, a temperature of the reaction chamber is controlled at 30°C to 60°C, and an inflow rate of the inert gas is 5 to 300 sccm.

5. The method for preparing the highly insulating nano-protective coating with the modulation structure according to claim 1, **characterized in that**: in the step (2): the monomer A vapor and the monomer B vapor or the monomer C vapor are introduced, plasma discharge is carried out to perform chemical vapor deposition, and in the deposition process, the plasma discharge process includes low-power continuous discharge, pulse discharge, or periodic alternate discharge.

6. The method for preparing the highly insulating nano-protective coating with the modulation structure according to claim 5, **characterized in that**: the plasma discharge process in the deposition process is the low-power continuous discharge, which specifically includes the following deposition processes at least once:
the deposition process comprises a pre-treatment stage and a coating stage, in the pre-treatment stage, plasma discharge power is 150 to 600 W, continuous discharge time is 60 to 450 s, and then it enters the coating stage, the plasma discharge power is adjusted to 10 to 150 W, and the continuous discharge time is 600 to 3600 s.

7. The method for preparing the highly insulating nano-protective coating with the modulation structure according to claim 5, **characterized in that**: the plasma discharge process in the deposition process is the pulse discharge, which specifically includes the following deposition processes at least once:
the deposition process includes a pre-treatment stage and a coating stage, in the pre-treatment stage, plasma discharge power is 150 to 600 W, continuous discharge time is 60 to 450 s, then it enters the coating stage, and the coating stage is pulse discharge, in the coating stage, the power is 10 to 300 W, the time is 600 s to 3600 s, a frequency of the pulse discharge is 1 to 1000 HZ, and a duty cycle of pulse is 1: 1 to 1: 500.

8. The method for preparing the highly insulating nano-protective coating with the modulation structure according to claim 5, **characterized in that**: the plasma discharge process in the deposition process is the periodic alternate discharge, which specifically includes the following deposition processes at least once:
the deposition process includes a pre-treatment stage and a coating stage, in the pre-treatment stage, plasma discharge power is 150 to 600 W, continuous discharge time is 60 to 450 s, and then it enters the coating stage, in the coating stage, the plasma is a periodic alternating discharge output, the power is 10 to 300 W, the time is 600 s to 3600 s, an alternating frequency is 1 to1000 Hz, and a waveform of the periodic alternating discharge output of the plasma is a sawtooth waveform, a sine waveform, a square wave waveform, a full-wave rectified waveform or a half-wave rectified waveform.

9. The method for preparing the highly insulating nano-protective coating with the modulation structure according to claim 1, **characterized in that**:
the low-dipole moment organic compound comprises:
paraxylene, benzene, toluene, carbon tetrafluoride, α-methylstyrene, polyparaxyl chloride, dimethylsiloxane, polydimethylsiloxane with a molecular weight of 500 to 50,000, allylbenzene, decafluorobiphenyl, decafluorobenzophenone, perfluoroallylbenzene, tetrafluoroethylene, hexafluoropropylene, 1H, 1H-perfluorooctylamine, perfluoroiodododecane, perfluorotributylamine, 1,8-diiodoperfluorooctane, perfluorohexyliodoane, perfluoroiodobutane, perfluoroiododecane, perfluorooctyliodoane, 1,4-bis(2',3'-epoxypropyl)perfluorobutane, dodecafluoro-2-methyl-2-pentene, 2-(perfluorobutyl)ethyl methacrylate, 2-(perfluorooctyl)ethyl methacrylate, 2-(perfluorooctyl)iodoethane, perfluorodecyl ethyl iodide, 1,1,2,2-tetrahydroperfluorohexyl iodide, perfluorobutyl ethylene, 1H,1H,2H-perfluoro-1-decene, 2,4,6-tris(perfluoroheptyl)-1,3,5-triazine, perfluorohexylethylene, 3-(perfluoron-octyl)-1,2,2-propylene oxide, perfluorocyclic ether, perfluorododecyl ethylene, perfluorododecyl ethyl iodide, dibromo-p-xylene, and 1,1,4,4-tetraphenyl-1,3-butadiene;
the monofunctional unsaturated fluorocarbon resin comprises:
3-(perfluoro-5-methylhexyl)-2-hydroxypropylmethacrylate, 2-(perfluorodecyl)ethylmethacrylate, 2-(perfluorohexyl)ethylmethacrylate, 2-(perfluorododecyl)ethyl acrylate, 2-perfluorooctyl ethyl acrylate, 1H,1H,2H,2H-perfluorooctanol acrylate, 2-(perfluorobutyl)ethyl acrylate, (2H-perfluoropropyl)-2-acrylate, (perfluorocyclohexyl)methacrylate, 3,3,3-trifluoro-1-propyne, 1-ethynyl-3,5-difluorobenzene or 4-ethynyltrifluorotoluene;
an organic silicon monomer includes a double-bond, Si-Cl, Si-O-C, Si-N-Si, Si-O-Si structure or a cyclic structure;
the organic silicon monomer with the double-bond structure comprises at least one of: allyltrimethoxysilane, vinyltriethoxysilane, vinyltrimethylsilane, 3-butenyltrimethylsilane, vinyltributanone oxime silane, tetramethyldivinyldisiloxane, and 1,2,2-trifluorovinyltriphenylsilane;
the organic silicon monomer including the Si-Cl bond comprises at least one of: triphenylchlorosilane, methylvinyldichlorosilane, trifluoropropyltrichlorosilane, trifluoropropylmethyldichlorosilane, dimethylphenylchlorosilane, tributylchlorosilane, and benzyldimethylchlorosilane;
the organic silicon monomer with the Si-O-C structure comprises at least one of: tetramethoxysilane, trimethoxyhydrosiloxane, n-octyltriethoxysilane, phenyltriethoxysilane, vinyltri(2-methoxy ethoxy)silane, triethylvinylsilane, hexaethylcyclotrisiloxane, 3-(methacryloyloxy)propyltrimethoxysilane, phenyltri(trimethylsiloxane)silane, diphenyldiethoxysilane, dodecyltrimethoxysilane, n-octyltriethoxysilane, dimethoxysilane, and 3-chloropropyltrimethoxysilane;
the organic silicon monomer including the Si-N-Si or Si-O-Si structure comprises at least one of: hexamethyldisilazylamine, hexamethylcyclotrisilaneamino, hexamethyldisilazane, and hexamethyldisilazide;
the organic silicon monomer including the cyclic structure comprises at least one of: hexamethylcyclotrisiloxane, octamethylcyclotetrasiloxane, hexaphenylcyclotrisiloxane, decamethylcyclopentasiloxane, octaphenylcyclotetrasiloxane, triphenylhydroxysilane, diphenyldihydroxysilane, bis(tritylsilyl)chromate, trifluoropropylmethylcyclotrisiloxane, 2,2,4,4-tetramethyl-6,6,8,8-tetraphenylcyclotetrasiloxane, tetramethyltetravinylcyclotetrasiloxane, 3-glycidyl ether oxypropyltriethoxysilane, and γ-glycidyl ether oxypropyltrimethoxysilane; and
the unsaturated hydrocarbons, polyfunctional unsaturated hydrocarbons and hydrocarbon derivatives comprises:
1,3-butadiene, isoprene, 1,4-pentadiene, ethoxylated trimethylolpropane triacrylate, tripropylene glycol diacrylate, polyethylene glycol diacrylate, 1,6-hexanediol diacrylate, ethylene glycol diacrylate, diethylene glycol divinyl ether, or neopentyl glycol diacrylate.

10. The method for preparing the highly insulating nano-protective coating with the modulation structure according to claim 1, **characterized in that**: in the step (2), a mode of the plasma discharge is radio-frequency discharge, microwave discharge, intermediate-frequency discharge, high-frequency discharge, or electric spark discharge, and waveforms of the high-frequency discharge and the intermediate-frequency discharge are sinusoidal or bipolar pulses.

## Patentansprüche

1. Verfahren zum Herstellen einer hochisolierenden Nanoschutzbeschichtung mit Modulationsstruktur, **dadurch gekennzeichnet, dass** es die folgenden Schritte umfasst:
(1) Vorbehandlung:
Anordnen eines Ausgangsmaterials in einer Reaktionskammer von Nanobeschichtungsausrüstung, kontinuierliches Entleeren der Reaktionskammer, sodass ein Vakuumgrad der Reaktionskammer auf 10 bis 200 mTorr gebracht wird, und Einleiten eines Edelgases He oder Ar oder eines Mischgases von He und Ar, und Einschalten eines Bewegungsmechanismus, damit sich das Ausgangsmaterial in der Reaktionskammer bewegt;
(2) Herstellen der hochisolierenden Nanobeschichtung:
wenigstens einmaliges Durchführen der folgenden Schritte, um eine Nanobeschichtung mit eine hochisolierenden Modulationsstruktur auf eine Oberfläche des Ausgangsmaterials herzustellen:
Einleiten von Monomer-A-Dampf in die Reaktionskammer bis zu einem Vakuumgrad von 30 bis 300 mTorr, Einschalten der Plasmaentladung zum Durchführen von chemischer Gasphasenabscheidung, Anhalten des Einleitens des Monomer-A-Dampfs, Einleiten von Monomer-B- oder Monomer-C-Dampf, Fortsetzen der Plasmaentladung zum Durchführen der chemischen Gasphasenabscheidung, und Anhalten des Einleitens des Monomer-B- oder Monomer-C-Dampfs;
wobei die Zusammensetzung des Monomer-A-Dampfs umfasst:
eine Mischung von wenigstens einer organischen Verbindung mit niedrigem Dipolmoment und wenigstens einem ungesättigten Kohlenwasserstoff, polyfunktionellen ungesättigten Kohlenwasserstoff und Kohlenwasserstoffderivat, wobei ein Masseanteil des ungesättigten Kohlenwasserstoffs, des polyfunktionellen ungesättigten Kohlenwasserstoffs und des Kohlenwasserstoffderivats in dem Monomer-A-Dampf 15 % bis 65 % beträgt;
die Zusammensetzung des Monomer- B-Dampfs umfasst:
eine Mischung von wenigstens einem monofunktionellen ungesättigten Fluorkohlenwasserstoffharz und wenigstens einem ungesättigten Kohlenwasserstoff, polyfunktionellen ungesättigtem Kohlenwasserstoff und Kohlenwasserstoffderivat, wobei ein Masseanteil des ungesättigten Kohlenwasserstoffs, des polyfunktionellen ungesättigten Kohlenwasserstoffs und des Kohlenwasserstoffderivats in dem Monomer-B-Dampf 15 % bis 65 % beträgt;
die Zusammensetzung des Monomer- C-Dampfs umfasst:
eine Mischung von wenigstens einem organischen Siliziummonomer mit einer Doppelbindungsstruktur von Si-Cl, Si-O-C, Si-N-Si, oder Si-O-Si oder einer zyklischen Struktur und wenigstens einem ungesättigten Kohlenwasserstoff, polyfunktionellem ungesättigtem Kohlenwasserstoff und Kohlenwasserstoffderivat, wobei ein Masseanteil des ungesättigten Kohlenwasserstoffs, des polyfunktionellen ungesättigten Kohlenwasserstoffs und des Kohlenwasserstoffderivats in dem Monomer-C-Dampf 15 % bis 65 % beträgt;
Durchflussraten des Einleitens von Monomer A, Monomer B und Monomer C jeweils 10 bis 1000 µl/min betragen; und
(3) Nachbehandlung:
Anhalten der Plasmaentladung, fortgesetztes Entleeren, um den Vakuumgrad der Reaktionskammer bei 10 bis 200 mTorr zu halten, nach 1 bis 5 min Einleiten von Luft auf Atmosphärendruck, Anhalten der Bewegung des Ausgangsmaterials und Herausnehmen des Ausgangsmaterials;
oder Anhalten der Plasmaentladung, Belüften der Reaktionskammer mit der Luft oder dem Edelgas auf einen Druck von 2000 bis 5000 mTorr, dann Entleeren auf 10 bis 200 mTorr, wenigstens einmaliges Durchführen der vorstehenden Belüftungs- und Entleerungsschritte, Einleiten der Luft bis Atmosphärendruck, Anhalten der Bewegung des Ausgangsmaterials und Herausnehmen des Ausgangsmaterials.

2. Verfahren zum Herstellen einer hochisolierenden Nanoschutzbeschichtung mit Modulationsstruktur nach Anspruch 1, **dadurch gekennzeichnet, dass**: das Ausgangsmaterial in Schritt (1) eine Bewegung in der Reaktionskammer erzeugt, eine Form der Bewegung des Ausgangsmaterials derart ist, dass das Ausgangsmaterial eine lineare Hin-und-her-Bewegung oder eine kurvenförmige Bewegung relativ zur Reaktionskammer vollzieht, wobei die kurvenförmige Bewegung eine Kreisbewegung, eine Ellipsenbewegung, eine Planetenbewegung, eine kugelförmige Bewegung oder kurvenförmige Bewegungen mit anderen unregelmäßigen Verläufen vollzieht.

3. Verfahren zum Herstellen einer hochisolierenden Nanoschutzbeschichtung mit Modulationsstruktur nach Anspruch 1, **dadurch gekennzeichnet, dass**: das Ausgangsmaterial in Schritt (1) ein Feststoffmaterial ist, das Feststoffmaterial ein elektronisches Produkt, ein elektrisches Bauteil, ein halbfertiges Produkt einer elektronischen Baugruppe, eine PCB, eine Metallplatte, eine Polytetrafluorethylenplatte oder ein elektronisches Bauelement ist, und nach dem Vorbereiten der Oberfläche des Ausgangsmaterials mit einer siliziumorganischen Nanobeschichtung eine Grenzfläche desselben zum Gebrauch einer Umgebung mit Wasser, einer Umgebung mit Schimmel und einer Umgebung mit saurem oder alkalischem Lösungsmittel, einer Umgebung mit saurem oder alkalischem Salznebel, einer Umgebung mit saurer Atmosphäre, einer Umgebung des Eintauchens in ein organisches Lösungsmittel, einer Kosmetikumgebung, einer Umgebung mit Schweiß, einer Umgebung mit Kälte- und Wärmezyklen oder einer abwechselnd feuchten und heißen Umgebung ausgesetzt werden kann.

4. Verfahren zum Herstellen einer hochisolierenden Nanoschutzbeschichtung mit Modulationsstruktur nach Anspruch 1, **dadurch gekennzeichnet, dass**: die Reaktionskammer in Schritt (1) eine würfelförmige Kammer mit einem Volumen von 50 bis 1000 I ist, eine Temperatur der Reaktionskammer auf 30 °C bis 60 °C gesteuert wird und eine Einströmrate des Edelgases 5 bis 300 sccm beträgt.

5. Verfahren zum Herstellen einer hochisolierenden Nanoschutzbeschichtung mit Modulationsstruktur nach Anspruch 1, **dadurch gekennzeichnet, dass**: in Schritt (2): der Monomer-A-Dampf und der Monomer-B-Dampf or the monomer C-Dampf eingeleitet werden, Plasmaentladung zum Durchführen chemischer Gasphasenabscheidung ausgeführt wird und der Plasmaentladungsprozess in dem Abscheidungsprozess kontinuierliche Entladung mit geringer Energie, gepulste Entladung oder periodische alternierende Entladung beinhaltet.

6. Verfahren zum Herstellen einer hochisolierenden Nanoschutzbeschichtung mit Modulationsstruktur nach Anspruch 5, **dadurch gekennzeichnet, dass**: Plasmaentladungsprozess in dem Abscheidungsprozess kontinuierliche Entladung mit geringer Energie ist und insbesondere wenigstens einmal die folgenden Abscheidungsprozesse beinhaltet:
wobei der Abscheidungsprozess eine Vorbehandlungsstufe und eine Beschichtungsstufe umfasst, wobei auf der Vorbehandlungsstufe die Plasmaentladungsenergie 150 bis 600 W beträgt, die kontinuierliche Entladungszeit 60 bis 450 s beträgt, woraufhin die Beschichtungsstufe beginnt und die Plasmaentladungsenergie auf 10 bis 150 W eingestellt wird und die kontinuierliche Entladungszeit 600 bis 3600 s beträgt.

7. Verfahren zum Herstellen einer hochisolierenden Nanoschutzbeschichtung mit Modulationsstruktur nach Anspruch 5, **dadurch gekennzeichnet, dass**: Plasmaentladungsprozess in dem Abscheidungsprozess gepulste Entladung ist und insbesondere wenigstens einmal die folgenden Abscheidungsprozesse beinhaltet:
wobei der Abscheidungsprozess eine Vorbehandlungsstufe und eine Beschichtungsstufe umfasst, wobei auf der Vorbehandlungsstufe die Plasmaentladungsenergie 150 bis 600 W beträgt, die kontinuierliche Entladungszeit 60 bis 450 s beträgt, woraufhin die Beschichtungsstufe beginnt und die Beschichtungsstufe gepulste Entladung ist, wobei die Energie auf der Beschichtungsstufe 10 bis 300 W beträgt, die Zeit 600 s bis 3600 s beträgt, eine Frequenz der gepulsten Entladung 1 bis 1000 Hz beträgt und ein Abtastverhältnis des Impulses 1:1 bis 1:500 beträgt.

8. Verfahren zum Herstellen einer hochisolierenden Nanoschutzbeschichtung mit Modulationsstruktur nach Anspruch 5, **dadurch gekennzeichnet, dass**: Plasmaentladungsprozess in dem Abscheidungsprozess periodische alternierende Entladung ist und insbesondere wenigstens einmal die folgenden Abscheidungsprozesse beinhaltet:
wobei der Abscheidungsprozess eine Vorbehandlungsstufe und eine Beschichtungsstufe umfasst, wobei auf der Vorbehandlungsstufe die Plasmaentladungsenergie 150 bis 600 W beträgt, die kontinuierliche Entladungszeit 60 bis 450 s beträgt, woraufhin die Beschichtungsstufe beginnt und auf der Beschichtungsstufe das Plasma eine periodische alternierende Entladungsausgabe ist, die Energie 10 bis 300 W beträgt, die Zeit 600 s bis 3600 s beträgt, eine Alternierungsfrequenz 1 bis 1000 Hz beträgt und eine Wellenform der periodischen alternierenden Entladungsausgabe des Plasmas eine Sägezahnwellenform, eine Sinuswellenform, eine Quadratwellenform, eine gleichgerichtete Vollwellenform oder eine gleichgerichtete Halbwellenform ist.

9. Verfahren zum Herstellen einer hochisolierenden Nanoschutzbeschichtung mit Modulationsstruktur nach Anspruch 1, **dadurch gekennzeichnet, dass**:
die organische Verbindung mit niedrigem Dipolmoment umfasst:
Paraxylol, Benzol, Toluol, Kohlenstofftetrafluorid, a-Methylstyrol, Polyparaxylchlorid, Dimethylsiloxan, Polydimethylsiloxan mit einem Molekulargewicht von 500 bis 50.000, Allylbenzol, Decafluorbiphenyl, Decafluorbenzophenon, Perfluorallylbenzol, Tetrafluorethylen, Hexafluorpropylen, 1H,1H-perfluorctylamin, Perfluoriodododecan, Perfluortributylamin, 1,8-Diiodperfluoroctan, Perfluorhexyliodoan, Perfluoriodobutan, Perfluoriododecan, Perfluoroctyliodoan, 1,4-Bis(2',3'-epoxypropyl)perfluorbutan, Dodecafluor-2-methyl-2-penten, 2-(Perfluorbutyl)ethylmethacrylat, 2-(Perfluoroctyl)ethylmethacrylat, 2-(Perfluoroctyl)iodethan, Perfluordecylethyliodid, 1,1,2,2-Tetrahydroperfluorhexyliodid, Perfluorbutylethylen, 1H,1H,2H-Perfluor-1-decen, 2,4,6-Tris(perfluorheptyl)-1,3,5-triazin, perfluorhexylethylene, 3-(Perfluoroctyl)-1,2,2-propylenoxid, perfluorcyclischer Ether, Perfluordodecyl ethylen, Perfluordodecylethyliodid, Dibromo-p-xylen, und 1,1,4,4-Tetraphenyl-1,3-butadien;
das monofunktionelle ungesättigte Fluorkohlenwasserstoffharz umfasst:
3-(Perfluor-5-methylhexyl)-2-hydroxypropylmethacrylat, 2-(perfluordecyl)ethylmethacrylat, 2-(Perfluorhexyl)ethylmethacrylat, 2-(Perfluordodecyl)ethylacrylat, 2-Perfluoroctylethylacrylat, 1H,1H,2H,2H-Perfluoroctanolacrylat, 2-(Perfluorbutyl)ethylacrylat, (2H-Perfluorpropyl)-2-acrylat, (Perfluorcyclohexyl)methacrylat, 3,3,3-Trifluor-1-propyn, 1-Ethynyl-3,5-difluorbenzol oder 4-Ethynyltrifluortoluol;
ein organisches Siliziummonomer eine Doppelbindungsstruktur mit Si-Cl, Si-O-C, Si-N-Si, Si-O-Si oder eine zyklische Struktur beinhaltet;
das organische Siliziummonomer mit Doppelbindungsstruktur wenigstens eins umfasst von: Allyltrimethoxysilan, Vinyltriethoxysilan, Vinyltrimethylsilan, 3-Butenyltrimethylsilan, Vinyltributanonoximsilan, Tetramethyldivinyldisiloxan, und 1,2,2-Trifluorvinyltriphenylsilan;
das organische Siliziummonomer mit Si-Cl-Bindung wenigstens eins umfasst von: Triphenylchlorosilan, Methylvinyldichlorosilan, Trifluorpropyltrichlorosilan, Trifluorpropylmethyldichlorosilan, Dimethylphenylchlorosilan, Tributylchlorosilan, und Benzyldimethylchlorosilane;
das organische Siliziummonomer mit Si-O-C-Struktur wenigstens eins umfasst von: Tetramethoxysilan, Trimethoxyhydrosiloxan, n-Octyltriethoxysilan, Phenyltriethoxysilan, Vinyltri(2-methoxyethoxy)silan, Triethylvinylsilan, Hexaethylcyclotrisiloxan, 3-(Methacryloyloxy)propyltrimethoxysilan, Phenyltri(trimethylsiloxane)silan, Diphenyldiethoxysilan, Dodecyltrimethoxysilan, n-Octyltriethoxysilan, Dimethoxysilan und 3-Chlorpropyltrimethoxysilane;
das organische Siliziummonomer mit Si-N-Si- oder Si-O-Si-Struktur wenigstens eins umfasst von: Hexamethyldisilazylamin, Hexamethylcyclotrisilanamino, Hexamethyldisilazan und Hexamethyldisilazid;
das organische Siliziummonomer mit der zyklischen Struktur wenigstens eins umfasst von: Hexamethylcyclotrisiloxan, Octamethylcyclotetrasiloxan, Hexaphenylcyclotrisiloxan, Decamethylcyclopentasiloxan, Octaphenylcyclotetrasiloxan, Triphenylhydroxysilan, Diphenyldihydroxysilan, Bis(tritylsilyl)chromat, Trifluorpropylmethylcyclotrisiloxan, 2,2,4,4-Tetramethyl-6,6,8,8-tetraphenylcyclotetrasiloxan, Tetramethyltetravinylcyclotetrasiloxan, 3-Glycidyletheroxypropyltriethoxysilan und γ-Glycidyletheroxypropyltrimethoxysilan; und
die ungesättigten Kohlenwasserstoffe, polyfunktionellen ungesättigten Kohlenwasserstoffe und Kohlenwasserstoffderivate umfassen:
1,3-Butadiene, Isopren, 1,4-Pentadien, ethoxyliertes Trimethylolpropantriacrylat, Tripropylenglycoldiacrylat, Polyethylenglycoldiacrylat, 1,6-Hexanedioldiacrylat, Ethylenglycoldiacrylat, Diethylenglycoldivinylether oder Neopentylglycoldiacrylat.

10. Verfahren zum Herstellen einer hochisolierenden Nanoschutzbeschichtung mit Modulationsstruktur nach Anspruch 1, **dadurch gekennzeichnet, dass**: in Schritt (2) ein Modus der Plasmaentladung Funkfrequenzentladung, Mikrowellenentladung, Mittelfrequenzentladung, Hochfrequenzentladung oder elektrische Funkenentladung ist und Wellenformen der Hochfrequenzentladung und der Mittelfrequenzentladung sinusförmige oder bipolare Impulse sind.

## Revendications

1. Un procédé pour préparer un revêtement nano-protecteur hautement isolant avec une structure de modulation, **caractérisée en ce qu'**il comprend les étapes suivantes :
(1) pré-traitement :
placer un matériau de base dans une chambre de réaction d'un équipement de préparation de nano-revêtement, mettre sous vide de façon continue la chambre de réaction de sorte qu'un degré de vide dans la chambre de réaction de 10 à 200 mTorr soit atteint, et introduire un gaz inerte de He ou Ar ou un gaz mélangé de He et de Ar, et mettre en marche un mécanisme de mouvement afin de faire bouger le matériau de base dans la chambre de réaction ;
(2) préparation du revêtement nano-protecteur hautement isolant :
réaliser les étapes suivantes au moins une fois pour préparer un nano-revêtement à structure de modulation hautement isolante sur une surface du matériau de base :
introduire une vapeur monomère A dans la chambre de réaction à degré de vide de 30 à 300 mTorr, allumer la décharge de plasma afin de réaliser un dépôt de vapeur chimique, arrêter l'introduction de vapeur monomère A, introduire une vapeur monomère B ou monomère C, poursuivre la décharge de plasma afin de réaliser un dépôt de vapeur chimique, et arrêter l'introduction de vapeur monomère B ou monomère C ;
dans lequel la composition de la vapeur monomère A comprend :
un mélange de au moins un composé organique à faible moment dipolaire et au moins un hydrocarbure non saturé, hydrocarbure non saturé polyfonctionnel et dérivé d'hydrocarbure, dans lequel la fraction massique de l'hydrocarbure non saturé, hydrocarbure non saturé polyfonctionnel et dérivé d'hydrocarbure dans la vapeur monomère A est de 15% à 65% ;
la composition de la vapeur monomère B comprend :
un mélange de au moins une résine fluoro-carbonée non saturée monofonctionnelle et au moins un hydrocarbure non saturé, hydrocarbure non saturé polyfonctionnel et dérivé d'hydrocarbure, dans lequel la fraction massique de l'hydrocarbure non saturé, hydrocarbure non saturé polyfonctionnel et dérivé d'hydrocarbure dans la vapeur monomère B est de 15% à 65% ;
la composition de la vapeur monomère C comprend :
un mélange d'au moins un monomère de silicium organique incluant une liaison double, une structure Si-CI, Si-O-C, Si-N-Si, ou Si-O-Si ou une structure cyclique et au moins un hydrocarbure non saturé, hydrocarbure non saturé polyfonctionnel et dérivé d'hydrocarbure, dans lequel la fraction massique de l'hydrocarbure non saturé, hydrocarbure non saturé polyfonctionnel et dérivé d'hydrocarbure dans la vapeur monomère C est de 15% à 65% ;
les débits d'introduction du monomère A, du monomère B et du monomère C sont chacun de 10 à 1000 pL/min ; et
(3) post-traitement :
arrêter la décharge de plasma, poursuivre la mise sous vide afin de maintenir le degré de vide de la chambre de réaction de 10 à 200 mTorr, après 1 à 5 min, introduire de l'air à pression atmosphérique, arrêter le mouvement du matériau de base, puis sortir le matériau de base ;
ou, arrêter la décharge de plasma, aérer la chambre de réaction à l'aide d'air ou de gaz inerte jusqu'à une pression de 2000 à 5000 mTorr, puis mettre sous vide de 10 à 200 mTorr, réaliser les étapes d'aération et de mise sous vide susmentionnées au moins une fois, introduire de l'air jusqu'à pression atmosphérique, arrêter le mouvement du matériau de base, puis sortir le matériau de base.

2. Un procédé pour préparer un revêtement nano-protecteur hautement isolant avec une structure de modulation selon la revendication 1, **caractérisé en ce que** : le matériau de base de l'étape (1) génère un mouvement dans la chambre de réaction, la forme de mouvement du matériau de base est telle que le matériau de base réalise un mouvement alternatif linéaire ou un mouvement curviligne par rapport à la chambre de réaction, et le mouvement curviligne inclut un mouvement circulaire, un mouvement elliptique, un mouvement planétaire, un mouvement sphérique, ou des mouvements curvilignes d'autres trajets irréguliers.

3. Un procédé pour préparer un revêtement nano-protecteur hautement isolant avec une structure de modulation selon la revendication 1, **caractérisé en ce que** : le matériau de base de l'étape (1) est un matériau solide, le matériau solide est un produit électronique, un composant électrique, un produit d'ensemble électronique semi-fini, un PCB, une plaque de métal, une plaque en polytétrafluoroéthylène ou un composant électronique, et une fois que la surface du matériau de base est préparée à l'aide d'un nano-revêtement d'organosilicium, toute interface pouvant être exposée à un environnement hydrique, un environnement à moisissures, un environnement à solvant acide ou alcalin, un environnement un brume de sel acide ou alcalin, un environnement atmosphérique acide, un environnement immergé à solvant organique, un environnement cosmétique, un environnement doux, un environnement à impact de cycle froid et chaud ou un environnement alternant humidité et chaleur pour utilisation.

4. Un procédé pour préparer un revêtement nano-protecteur hautement isolant avec une structure de modulation selon la revendication 1, **caractérisé en ce que** : la chambre de réaction à l'étape (1) est une chambre de forme cubique d'un volume de 50 à 1000 L, la température de la chambre de réaction est contrôlée de 30°C à 60°C, et le débit d'arrivée de gaz inerte est de 5 à 300 sccm.

5. Un procédé pour préparer un revêtement nano-protecteur hautement isolant avec une structure de modulation selon la revendication 1, **caractérisé en ce que** : à l'étape (2) : la vapeur monomère A et la vapeur monomère B ou la vapeur monomère C sont introduites, la décharge de plasma est réalisée pour effectuer un dépôt de vapeur chimique, et au cours du processus de dépôt, le processus de décharge de plasma inclut une décharge continue à faible puissance, une décharge d'impulsions, ou une décharge alternée périodique.

6. Un procédé pour préparer un revêtement nano-protecteur hautement isolant avec une structure de modulation selon la revendication 5, **caractérisé en ce que** : le processus de décharge de plasma du processus de dépôt est une décharge continue à faible puissance, qui inclut spécifiquement au moins une fois les processus de dépôt suivants :
le processus de dépôt comprend une phase de pré-traitement et une phase de revêtement, dans la phase de pré-traitement, la puissance de décharge de plasma est de 150 à 600 W, la durée de décharge continue est de 60 à 450 s, puis il passe à la phase de revêtement, la puissance de décharge de plasma est ajustée de 10 à 150 W, et la durée de décharge continue est de 600 à 3600 s.

7. Un procédé pour préparer un revêtement nano-protecteur hautement isolant avec une structure de modulation selon la revendication 5, **caractérisé en ce que** : le processus de décharge de plasma du processus de dépôt est une décharge d'impulsions, qui inclut spécifiquement au moins une fois les processus de dépôt suivants :
le processus de dépôt comprend une phase de pré-traitement et une phase de revêtement, dans la phase de pré-traitement, la puissance de décharge de plasma est de 150 à 600 W, la durée de décharge continue est de 60 à 450 s, puis il passe à la phase de revêtement, et la phase de revêtement est une décharge d'impulsions, dans la phase de revêtement, la puissance est de 10 à 300 W, la durée est de 600 s à 3600 s, la fréquence de la décharge d'impulsions est de 1 à 1000 HZ, et le rapport cyclique d'impulsion est de 1 : 1 à1 : 500.

8. Un procédé pour préparer un revêtement nano-protecteur hautement isolant avec une structure de modulation selon la revendication 5, **caractérisé en ce que** : le processus de décharge de plasma du processus de dépôt est la décharge alternée périodique, qui inclut spécifiquement au moins une fois les processus de dépôt suivants :
le processus de dépôt comprend une phase de pré-traitement et une phase de revêtement, dans la phase de pré-traitement, la puissance de décharge de plasma est de 150 à 600 W, la durée de décharge continue est de 60 à 450 s, puis il passe à la phase de revêtement, dans la phase de revêtement, le plasma est une sortie de décharge alternée périodique, la puissance est de 10 à 300 W, la durée est de 600 s à 3600 s, la fréquence alternée est de 1 à 1000 Hz, et la forme d'onde de la sortie de décharge alternée périodique du plasma est une forme d'onde en dent de scie, une forme d'onde carrée, une forme d'onde redressée en pleine-onde ou une forme d'onde redressée en demi-onde.

9. Un procédé pour préparer un revêtement nano-protecteur hautement isolant avec une structure de modulation selon la revendication 1, **caractérisé en ce que** :
le composé organique à faible moment dipolaire comprend :
du paraxylène, benzène, toluène, tétrafluorure de carbone, a-méthylstyrène, chlorure de polyparaxyle, diméthylsiloxane, polydiméthylsiloxane de poids moléculaire de 500 à 50 000, allylbenzène, décafluorobiphényle, décafluorobenzophénone, perfluoroallylbenzène, tétrafluoroéthylène, hexafluoropropylène, 1H,1H-perfluorooctylamine, perfluoroiodododécane, perfluorotributylamine, 1,8-diiodoperfluorooctane, perfluorohexyliodoane, perfluoroiodobutane, perfluoroiododécane, perfluorooctyliodoane, 1,4-bis(2',3'-époxypropyl)perfluorobutane, dodécafluoro-2-méthyl-2-pentène, 2-(perfluorobutyl)éthyl méthacrylate, 2-(perfluorooctyl)éthyl méthacrylate, 2-(perfluorooctyl)iodoéthane, iodure de perfluorodecyléthyl, iodure de 1,1,2,2-tétrahydroperfluorohexyle, perfluorobutyle éthylène, 1H,1H,2H-perfluoro-1-décène, 2,4,6-tris(perfluorohéptyl)-1,3,5-triazine, perfluorohexyléthylène, oxyde de 3-(perfluoron-octyl)-1,2,2-propylène, éther perfluorocyclique, perfluorododécyle éthylène, iodure de perfluorododécyle éthylé, dibromo-p-xylène, et du 1,1,4,4-tétraphényl-1,3-butadiène ;
la résine fluorocarbonée non saturée monofonctionnelle comprend :
du 3-(perfluoro-5-méthylhexyl)-2-hydroxypropylméthacrylate, 2-(perfluorodécyl)éthylméthacrylate, 2-(perfluorohexyl)éthylméthacrylate, 2-(perfluorododécyl)éthyle acrylate, 2-perfluorooctyle éthyle acrylate, 1H,1H,2H,2H-perfluorooctanol acrylate, 2-(perfluorobutyl)éthyle acrylate, (2H-perfluoropropyl)-2-acrylate, (perfluorocyclohexyl)méthacrylate, 3,3,3-trifluoro-1-propyne, 1-éthynyl-3,5-difluorobenzène ou du 4-éthynyltrifluorotoluène ;
le monomère de silicium organique inclut une liaison double, une structure Si-CI, Si-O-C, Si-N-Si, ou Si-O-Si ou une structure cyclique ;
le monomère de silicium organique à structure à liaison double comprend au moins un élément parmi : l'allyltriméthoxysilane, vinyltriéhoxysilane, vinyltriméthylsilane, 3-butényltriméthylsilane, vinyltributanone oxime silane, tétraméthyldivinyldisiloxane, et le 1,2,2-trifluorovinyltriphénylsilane ;
le monomère de silicium organique incluant la liaison Si-CI comprend au moins un élément un parmi : le triphénylchlorosilane, méthylvinyldichlorosilane, trifluoropropyltrichlorosilane, trifluoropropylméthyldichlorosilane, diméthylphénylchlorosilane, tributylchlorosilane, et le benzyldiméthylchlorosilane ;
le monomère de silicium organique à structure Si-O-C comprend au moins un élément un parmi : le tétramethoxysilane, triméthoxyhydrosiloxane, n-octyltriéthoxysilane, phényltriethoxysilane, vinyltri(2-méthoxy éthoxy)silane, triéthylvinylsilane, hexaéthylcyclotrisiloxane, 3-(méthacryloyloxy)propyltriméthoxysilane, phényltri(triméthylsiloxane)silane, diphényldiéthoxysilane, dodécyltriméthoxysilane, n-octyltriéthoxysilane, diméthoxysilane, et le 3-chloropropyltriméthoxysilane ;
le monomère de silicium organique incluant la structure Si-N-Si ou Si-O-Si comprend au moins élément un parmi : l'hexaméthyldisilazylamine, hexaméthylcyclotrisilaneamino, hexaméthyldisilazane, et l'hexaméthyldisilazide ;
le monomère de silicium organique incluant la structure cyclique comprend au moins un élément un parmi : l'hexaméthylcyclotrisiloxane, octaméthylcyclotétrasiloxane, hexaphénylcyclotrisiloxane, décaméthylcyclopentasiloxane, octaphénylcyclotétrasiloxane, triphénylhydroxysilane, diphényldihydroxysilane, bis(tritylsilyl)chromate, trifluoropropylméthylcyclotrisiloxane, 2,2,4,4-tétramethyl-6,6,8,8-tétraphenylcyclotétrasiloxane, tétraméthyltétravinylcyclotétrasiloxane, éther 3-glycidyle oxypropyltriéthoxysilane, et l'éther γ-glycidyl oxypropyltriméthoxysilane ; et
les hydrocarbures non saturés, hydrocarbures non saturés polyfonctionnels et dérivés d'hydrocarbures comprennent :
du 1,3-butadiène, isoprène, 1,4-pentadiène, éthoxylated triméthylolpropane tri acrylate, tripropylène glycol diacrylate, polyéthylène glycol diacrylate, 1,6-hexanédiol di acrylate, éthylène glycol di acrylate, di éthylène glycol divinyl éther, ou du néopentyl glycol diacrylate.

10. Un procédé pour préparer un revêtement nano-protecteur hautement isolant avec une structure de modulation selon la revendication 1, **caractérisé en ce que** : à l'étape (2), le mode de décharge de plasma est une décharge de fréquences radio, une décharge de micro-ondes, une décharge de fréquences intermédiaires, une décharge de hautes fréquences, ou une décharge d'étincelles électriques, et les formes d'ondes de la décharge à hautes fréquences et de la décharge de fréquences intermédiaires sont des impulsions sinusoïdales ou bipolaires.
